# EUROPEAN PATENT SPECIFICATION

(11) **EP 4 462 226 B1**
(45) Date of publication and mention of the grant of the patent: **01.04.2026**
(21) Application number: 23753136.3
(22) Date of filing: 08.02.2023
(51) Int. Cl.: G06F 1/16, G06F 3/041, H04M 1/02, E05D 3/12

(54) **ELECTRONIC DEVICE COMPRISING HINGE DEVICE**
ELEKTRONISCHE VORRICHTUNG MIT SCHARNIERVORRICHTUNG
DISPOSITIF ÉLECTRONIQUE COMPRENANT UN DISPOSITIF DE CHARNIÈRE

(30) Priority: 09.02.2022 KR 20220016873
(43) Date of publication of application: 13.11.2024
(73) Proprietor: Samsung Electronics Co., Ltd., Suwon-si, Gyeonggi-do 16677 (KR)
(72) Inventor: PARK, Joongkyung, Suwon-si, Gyeonggi-do 16677 (KR); PARK, Junghoon, Suwon-si, Gyeonggi-do 16677 (KR); SHIN, Wonho, Suwon-si, Gyeonggi-do 16677 (KR); YOO, Minwoo, Suwon-si, Gyeonggi-do 16677 (KR)
(74) Representative: Gulde & Partner
(86) International application number: PCT/KR2023/001797
(87) International publication number: WO 2023/153788

(56) References cited:
- EP-A1- 3 734 946
- WO-A1-2021/173116
- CN-A- 112 732 020
- CN-A- 114 006 962
- KR-A- 20150 081 178
- KR-A- 20210 068 880
- KR-A- 20210 106 869
- US-A1- 2021 081 006
- US-A1- 2021 247 815
- US-A1- 2021 373 611
- US-A1- 2021 373 612
- US-A1- 2023 403 347

## Description

### [Technical Field]

The various embodiments disclosed in the present document relate to an electronic device comprising a hinge device.

### [Background Art]

The hinge structure is widely used throughout the industry as a structure for rotatably connecting the instruments. For example, a hinge structure may be applied to a foldable electronic device.

With the technological development of components included in electronic devices, various types of electronic devices are being developed. In particular, with the development of displays that can be folded in accordance with the technological development of displays that visually display information, a new concept of electronic devices is emerging.

For example, a foldable electronic device can be implemented by applying a foldable display. As electronic devices of these new form factors emerge, the demand for technology development for components that rotatably connect housings of electronic devices is also gradually increasing.

CN 114 006 962 A discloses a folding mechanism is applied to a housing apparatus of an electronic device. The folding mechanism is configured to connect two housings of the housing apparatus. The folding mechanism can form display accommodating space through automatic avoidance in a folding process, and a flexible display is accommodated in the display accommodating space, so that a folding action performed by the housing apparatus on the flexible display is stable, and a squeezing force is small.

US 2021/373611 A1, discloses a foldable hinge module for a portable terminal that can easily unfold or fold a flexible display mounted on the portable terminal. In the foldable hinge module for a portable terminal, the flexible display can be smoothly unfolded or folded as the first rotary plate and the second rotary plate are easily rotated in the Y axis direction, by using the gear set part engaged with the first gear part formed in the first rotary plate and the second gear part formed in the second rotary plate to be operated.

US 2021/081006 A1 discloses a display device including a first panel including an input section, a second panel, a hinge section disposed between the first panel and the second panel, the hinge section being extended to the first panel and the second panel, a controller that receives an input signal from the input section and generates a control signal, and a hinge driving section that drives the hinge section based on the control signal from the controller.

### [Disclosure of Invention]

### [Technical Problem]

To increase the usability of foldable electronic devices, a stopping operation and a free-stop operation may be required. A stopping operation may mean an operation of maintaining the electronic device in a fully folded or fully unfolded state. A free-stop operation may mean an operation in which an electronic device maintains its state when no external force exceeding a certain level is applied in the process of transitioning from a folded state to an unfolded state.

The stopping operation of the foldable electronic device may maintain the state by applying force in the folding direction when the electronic device is fully folded, and by applying force in the unfolding direction when the electronic device is fully unfolded. The force exerted by such a stopping operation may increase the inconvenience of the user opening and closing the foldable electronic device with one hand, and damage to a part of the display may occur due to the user's force in the process of opening and closing the foldable electronic device.

In the various embodiments disclosed in the present document, a drive device such as a motor may be connected to the hinge device of the foldable electronic device so that the foldable electronic device can be opened and closed relatively simply. Through this, the foldable electronic device may be opened and closed as the user operates an external input device (e.g., a button) of the foldable electronic device.

### [Solution to Problem]

The present invention is defined by the appended set of claims. Preferred embodiments are defined by the dependent claims. An electronic device according to present invention comprises a first housing, a second housing, and a hinge device foldably connecting the first and second housings. The hinge device may comprise: a bracket comprising a first rail and a second rail spaced apart from the first rail; a first rotating member comprising a first rotating portion fastened to the first rail of the bracket so as to rotate with regard to the bracket; a second rotating member comprising a second rotating portion fastened to the second rail of the bracket so as to rotate with regard to the bracket; a first arm which comprises a first gear, which is connected to the first rotating member to be able to rotate with regard to the bracket, and which is connected to the first housing; a second arm which comprises a second gear, which is connected to the second rotating member to be able to rotate with regard to the bracket, and which is connected to the second housing; an interworking gear meshing with the first and second gears and rotating accordingly; a first limiting member disposed on the bracket, the first limiting member comprising a first body portion, a first contact portion and a first pressurizing member made of an elastic material so as to pressurize the first contact portion against the first rotating portion; and a second limiting member disposed on the bracket, the second limiting member comprising a second body portion, a second contact portion and a second pressurizing member made of an elastic material so as to pressurize the second contact portion against the second rotating portion; and a shaft penetrating the bracket and being configured to connect the first body portion and the second body portion, wherein the first body portion and the second body portion are configured to rotate with regard to the bracket.

### [Advantageous Effects of Invention]

In the various embodiments disclosed in the present document, a drive device such as a motor may be connected to the hinge device of the foldable electronic device so that the foldable electronic device can be opened and closed relatively simply. Through this, the user may open and close the foldable electronic device by operating the drive device connected to the hinge device by manipulating the external input device (e.g., a button) of the foldable electronic device.

Therefore, the user may not manually open and close the foldable electronic device, which can increase the usability of the foldable electronic device.

### [Brief Description of Drawings]

In relation to the description of the drawings, identical or similar reference numerals may be used for identical or similar components.
FIG. 1 is a block diagram of an electronic device in a network environment according to various embodiments.
FIG. 2a is a front view of an electronic device according to various embodiments disclosed in the present document.
FIG. 2b is a perspective view of an electronic device according to various embodiments disclosed in the present document.
FIG. 2c is a perspective view of an electronic device in a folded state according to various embodiments disclosed in the present document.
FIG. 3a is an exploded perspective view of an electronic device according to various embodiments disclosed in the present document.
FIG. 3b is a diagram illustrating a hinge device assembled to an electronic device according to various embodiments disclosed in the present document.
FIG. 4a is a perspective view of a hinge device according to various embodiments disclosed in the present document.
FIG. 4b is a top and side view of a hinge device according to various embodiments disclosed in the present document.
FIG. 4c is an exploded perspective view of a hinge device according to various embodiments disclosed in the present document.
FIG. 5 is a cross-sectional view of the hinge device taken along line B - B shown in FIG. 4a.
FIG. 6a is a diagram explaining the operation of the hinge device when the electronic device is in a folded state.
FIG. 6b is a diagram explaining the operation of the hinge device when the electronic device is in an intermediate state.
FIG. 6c is a diagram explaining the operation of the hinge device when the electronic device is in an unfolded state.
FIG. 6d is a diagram illustrating a state in which a roller of a limiting member is in contact with a stop portion concavely formed in a rotating portion of a hinge device when the electronic device is in an unfolded state.
FIG. 7 is a diagram illustrating the torque generated by the display module, the torque generated by the transmission device, and the torque generated by the limiting member.
FIG. 8a is a processor flowchart for an unfolding operation of an electronic device.
FIG. 8b is a processor flowchart for a folding operation of an electronic device.
FIG. 9a is an exploded perspective view of a hinge device according to another embodiment disclosed in the present document.
FIG. 9b is a front view of a hinge device according to another embodiment disclosed in the present document.
FIG. 10a is a front view of a hinge device according to another embodiment disclosed in the present document.
FIG. 10b is a diagram illustrating the gear interworking structure of a hinge device according to another embodiment disclosed in the present document.
FIG. 10c is a side view of FIG. 10a.

### [Mode for the Invention]

It should be appreciated that various embodiments of the present disclosure and the terms used therein are not intended to limit the technological features set forth herein to particular embodiments and include various changes, equivalents, or replacements for a corresponding embodiment within the scope defined by the appended set of claims.

With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

In the following description, although numerous features may be designated as optional, it is nevertheless acknowledged that all features defined by claim 1 are not to be read as optional.

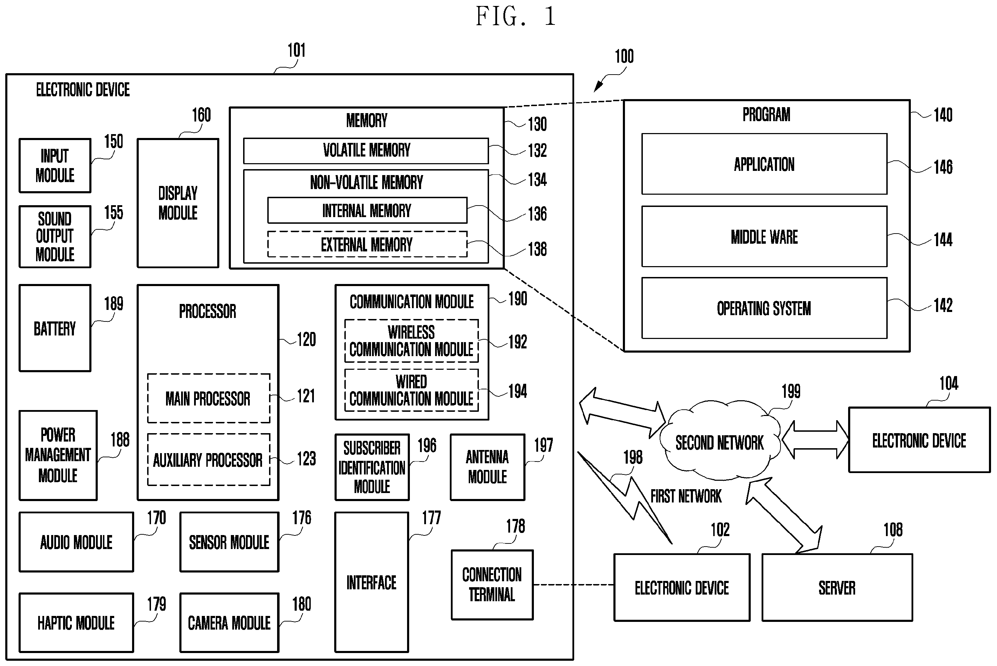

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

In the following description, the same member number will be used for all identical or similar components, except as otherwise indicated. In addition, the description of the same member number may be omitted.

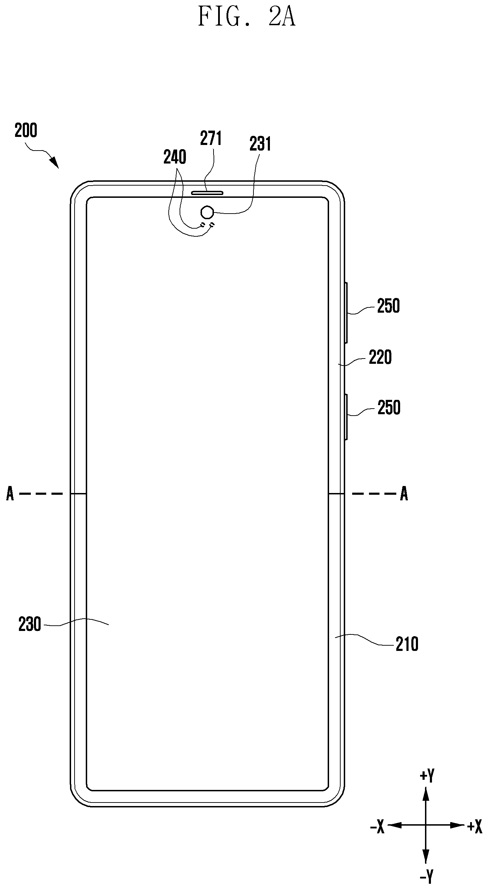

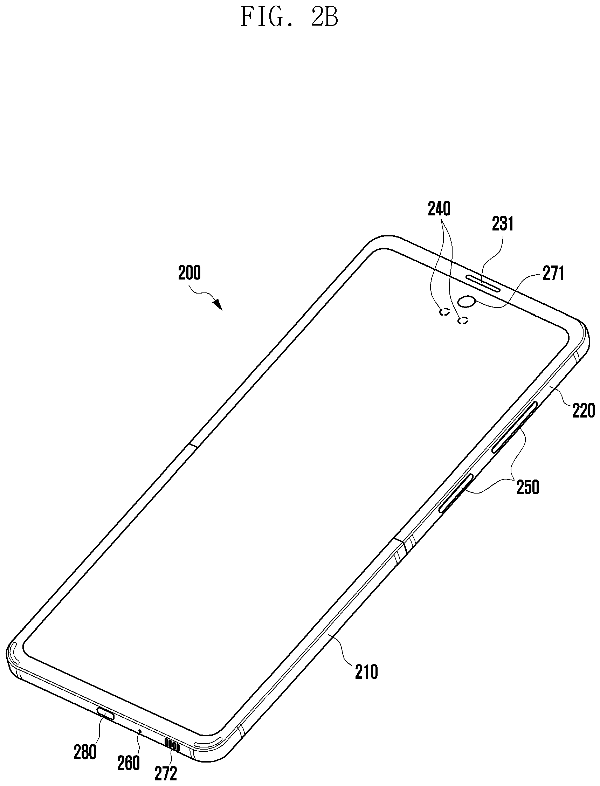

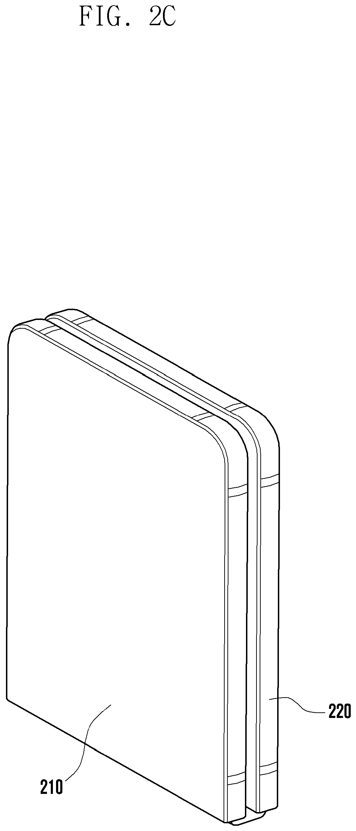

FIG. 2a is a front view of an electronic device according to various embodiments disclosed in the present document. FIG. 2b is a perspective view of an electronic device according to various embodiments disclosed in the present document. FIG. 2c is a perspective view of an electronic device in a folded state according to various embodiments disclosed in the present document.

According to various embodiments, the electronic device 200 shown in FIGS. 2a to 2c may be an embodiment of the electronic device 101 previously described with reference to FIG. 1. The electronic device 200 described below may include at least some of the components shown in FIG. 1.

According to various embodiments, the electronic device 200 may include a first housing 210 and a second housing 220. The first housing 210 and the second housing 220 may be connected in a foldable manner. For example, as shown in FIG. 2c, the overall shape of the electronic device 200 may be changed by folding the first housing 210 and the second housing 220. In one embodiment, the first housing 210 and the second housing 220 may be folded about an axis (e.g., axis A-A of FIG. 2a) that is parallel to the width direction (e.g., X axis direction of FIG. 2a) of the electronic device 200. In another embodiment, the first housing 210 and the second housing 220 may be folded about an axis that is parallel to the longitudinal direction (e.g., the Y axis direction of FIG. 2a) of the electronic device 200.

According to various embodiments, the electronic device 200 may include a display module 230 (e.g., the display module 160 of FIG. 1) supported in the first housing 210 and the second housing 220. The display module 230 may include a whole range of devices capable of displaying visual information. In one embodiment, the display module 230 may be at least partially folded by folding the first housing 210 and the second housing 220. Here, the folding of the display module 230 may include both a completely folded deformation and a deformation that bends while maintaining a predetermined curvature.

According to various embodiments, the display module 230 may be a flexible display with at least some area foldable. In one embodiment, the substrate of the display module 230 may be formed of a flexible material. For example, the substrate of the display module 230 may be formed of a polymer material such as polyethylene terephthalate (PET), polyimide (PI), or glass processed to a very thin thickness.

With reference to FIG. 2c, the first housing 210 and the second housing 220 may substantially face each other when the electronic device 200 is folded. In this way, the electronic device 200 may be folded to improve the portability of the electronic device 200, so that it may be possible to make the electronic device 200 containing the large-area display module 230 more compact. In addition, since the portion of the display module 230 exposed to the outside is reduced in the folded state as shown in FIG. 2c, the damage or contamination of the display module 230 may be prevented.

According to various embodiments, the display module 230 may include a hole 231 for transmitting external light to a camera module (e.g., the camera module 180 of FIG. 1) that may be disposed on the rear surface of the display module 230. For example, as shown in FIG. 2a, a hole 231 that transmits light to the camera module may be located at the top of the display module 230. In one embodiment, various sensor modules (e.g., infrared sensors, illuminance sensors) 240 related to light may be disposed around the hole 231.

According to various embodiments, the electronic device 200 may include a physical button 250 that can generate an electrical signal when pressed by an external force. For example, as shown in FIGS. 2a and 2b, at least one physical button 250 may be disposed on the side of the electronic device 200.

According to various embodiments, the electronic device 200 may include a microphone hole 260 and speaker holes 271 and 272. A microphone for acquiring external sound may be disposed inside the microphone hole 260, and in some embodiments, a plurality of microphones may be placed to detect the direction of the sound. The speaker holes 271 and 272 may include an external speaker hole 272 and a receiver hole 271 for a call. In some embodiments, the speaker holes 271 and 272 and the microphone hole 260 may be implemented as one hole, or only a speaker may be included without the speaker holes 271 and 272 (e.g., piezo speaker).

According to various embodiments, the electronic device 200 may include a connection interface 280 (e.g., the interface 177 of FIG. 1). The connection interface 280 may include, for example, a high definition multimedia interface (HDMI), a universal serial bus (USB) interface, an SD card interface, and/or an audio interface. In one embodiment, the connection interface 280 may electrically or physically connect the electronic device 200 to an external electronic device and may include a USB connector, SD card/MMC connector, or audio connector. For example, as shown in FIG. 2b, a connector 280 that can be connected to an external electronic device (e.g., another electronic device, charging device, audio device, etc.) may be disposed at the bottom of the electronic device 200.

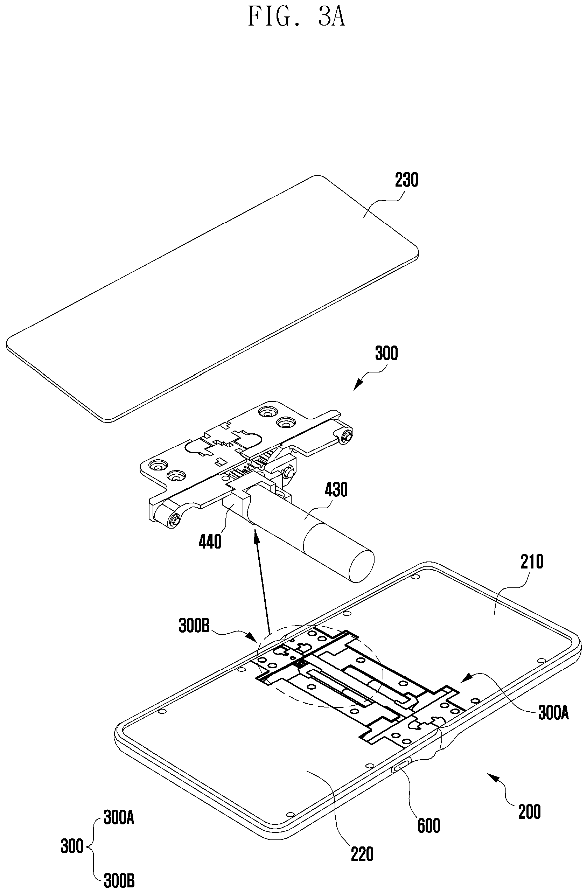

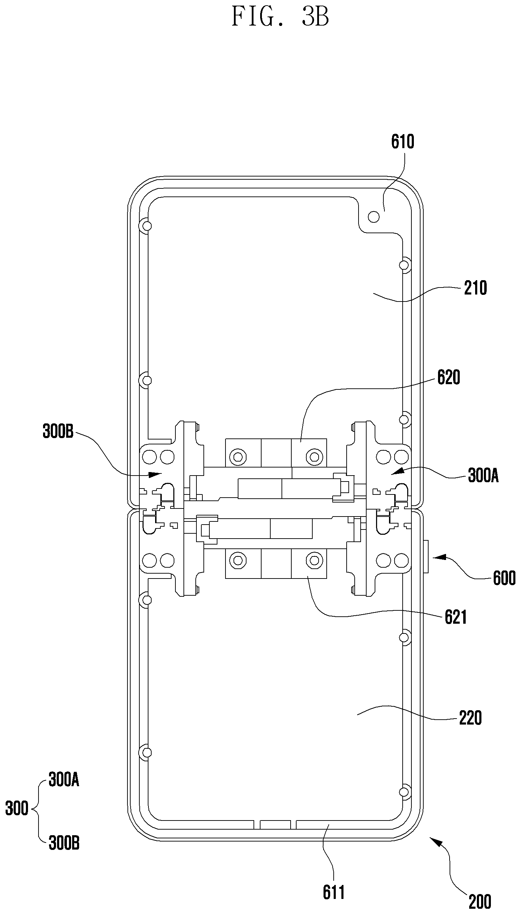

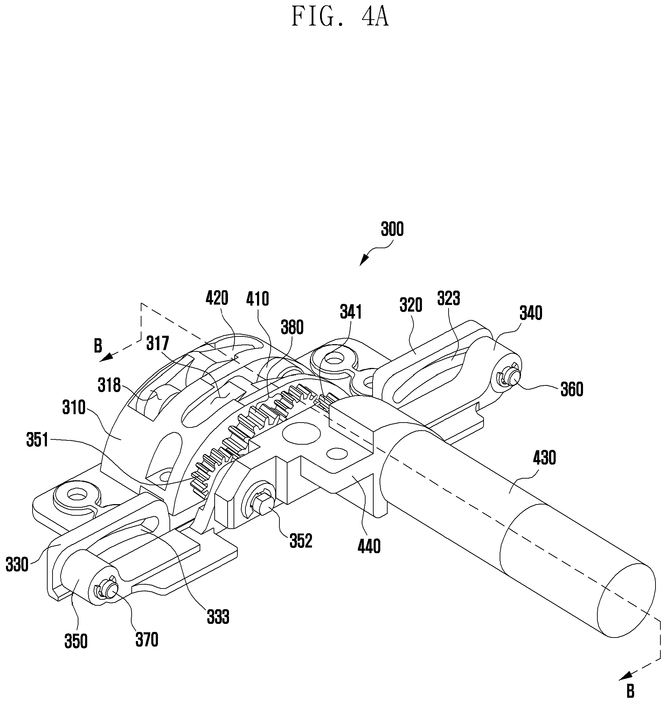

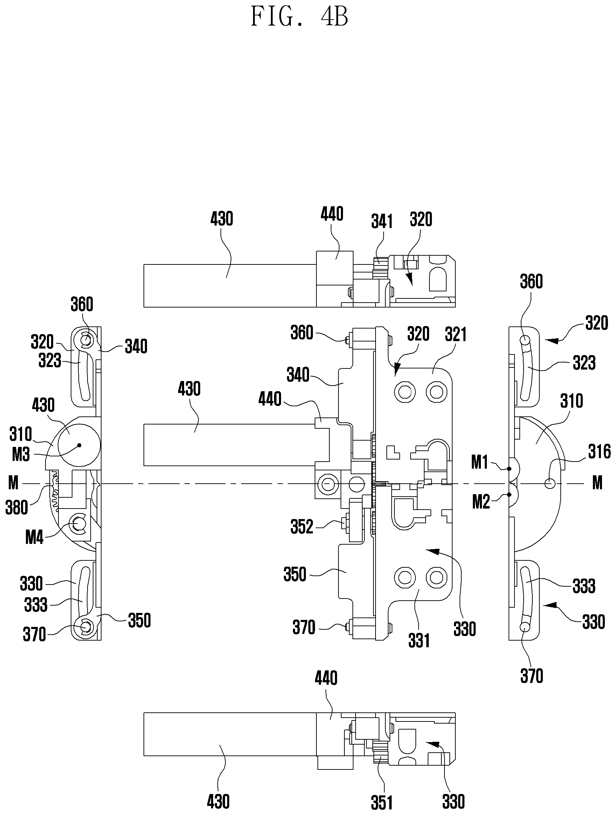

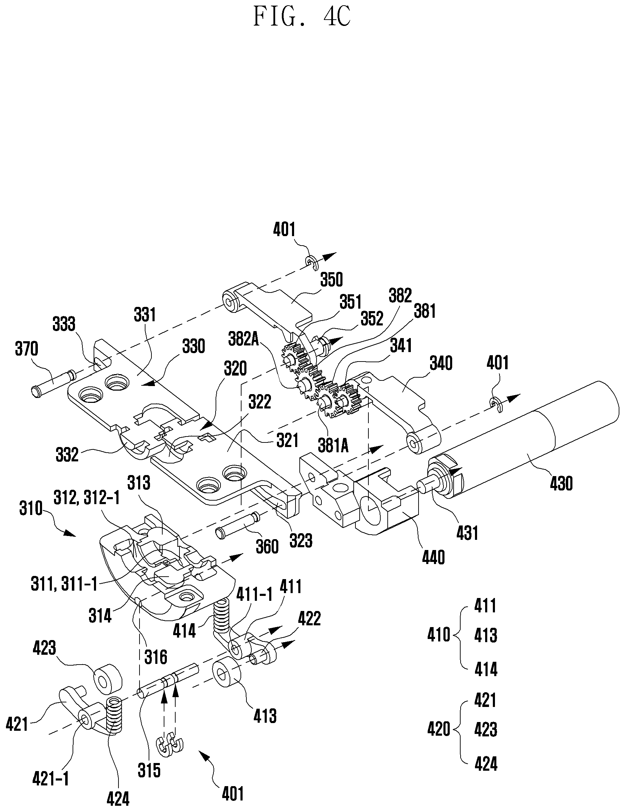

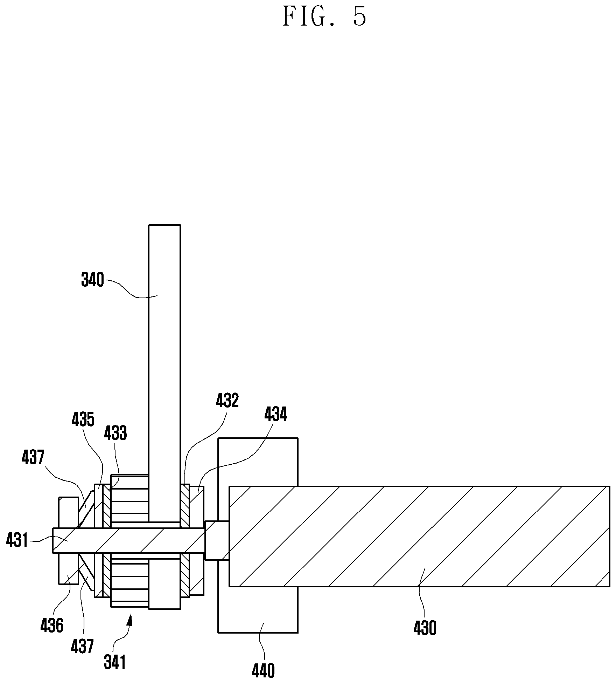

FIG. 3a is an exploded perspective view of an electronic device according to various embodiments disclosed in the present document. FIG. 3b is a diagram illustrating a hinge device assembled to an electronic device according to various embodiments disclosed in the present document. FIG. 4a is a perspective view of a hinge device according to various embodiments disclosed in the present document. FIG. 4b is a top and side view of a hinge device according to various embodiments disclosed in the present document. FIG. 4c is an exploded perspective view of a hinge device according to various embodiments disclosed in the present document. FIG. 5 is a cross-sectional view of the hinge device taken along line B - B shown in FIG. 4a.

According to various embodiments, the first housing 210 and the second housing 220 may be foldably connected by a hinge device 300. Depending on the degree to which the first housing 210 and the second housing 220 are rotated by the hinge device 300, the "unfolded state" in which the electronic device 200 is unfolded may be switched to the "folded state" in which the electronic device 200 is folded and to an "intermediate" state that is intermediate between the unfolded state and the folded state. Accordingly, the electronic device 200 may be switched from the unfolded state to the unfolded state, or from the folded state to the unfolded state, by the folding or unfolding of the first housing 210 and the second housing 220 through the hinge device 300.

According to various embodiments, as shown in FIGS. 3a and 3b, a plurality of hinge devices 300A and 300B (collectively referred to as a hinge device 300) may be provided and disposed between the first housing 210 and the second housing 220. However, the electronic device 200 disclosed in the present disclosure is not limited to the number of hinge devices 300. **In** consideration of the size and load capacity of the hinge device 300, the number of hinge devices 300 included in the electronic device 200 may vary. The hinge device 300 may be combined with the first housing 210 and the second housing 220. By folding or unfolding the hinge device 300, the first housing 210 and the second housing 220 coupled to the hinge device 300 may move together with the hinge device 300.

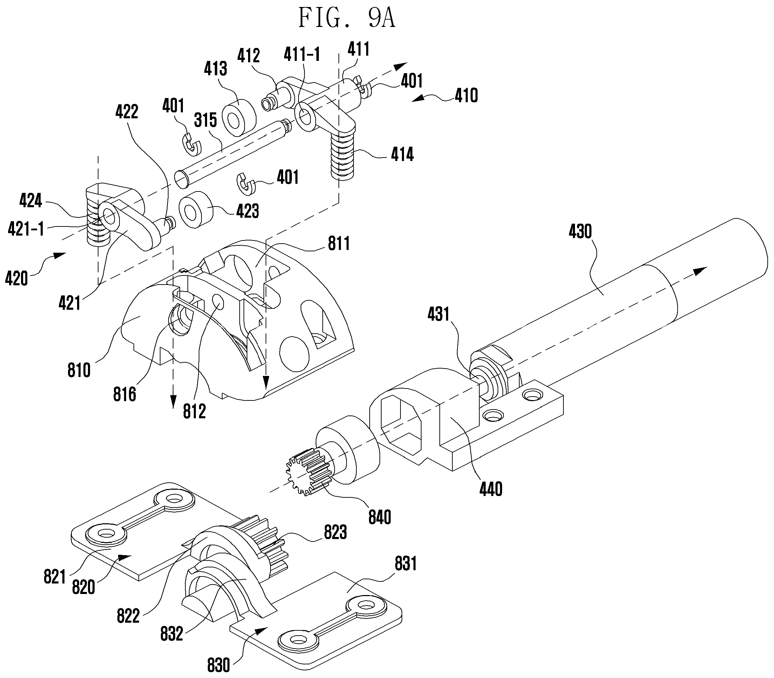

According to various embodiments, as shown in FIG. 4a to 4c, the hinge device 300 may include a bracket 310, a first rotating member 320, a second rotating member 330, a first arm 340, a second arm 350, a first limiting member 410, a second limiting member 420, an interworking gear 380 and a drive device 430. The components of the hinge device 300 described above are only illustrative, and at least one of the above configurations may be omitted as necessary, and it is possible to configure the hinge device 300 by adding other components. For example, the first arm 340, the second arm 350 and the drive device 430 may be omitted as needed. With reference to FIGS. 9a to 10b to be discussed later, the first arm 340 and the second arm 350 may be omitted.

According to various embodiments, the bracket 310 may be a body of the hinge device 300 in which components of the hinge device 300 can be coupled to each other. Components of the hinge device 300 may be disposed around the bracket 310 and may be coupled to or interworked with each other. A first rotating member 320 and a second rotating member 330 may rotate about the center of the bracket 310, and a first arm 340 connected to the first rotating member 320 and a second arm 350 connected to the second rotating member 330 may rotate. The center M of the bracket 310 may be the rotating center of the hinge device 300. Accordingly, the bracket 310 may be disposed on the first housing 210 and the second housing 220 so that the center M of the bracket 310 and the rotating center of the electronic device 200 (e.g., the A axis of FIG. 3b) coincide. The brackets 310 may be formed of a variety of materials. For example, the brackets 310 may be formed of a metal material, a synthetic resin material, etc. In one embodiment, the bracket 310 may be formed of a highly rigid material to stably support the various components of the hinge device 300.

According to various embodiments, as shown in FIG. 4c, the bracket 310 may include a first rail 311 and a second rail 312. The first rail 311 may be a portion that is fastened to the first rotating portion 322 of the first rotating member 320. The first rotating portion 322 may be a portion of the first rotating member 320 and may be a portion inserted into the first rail 311. The second rail 312 may be a portion that is fastened to the second rotating portion 332 of the second rotating member 330. The second rotating portion 332 is a portion of the second rotating member 330 and may be a portion inserted into the second rail 312. The first rotating portion 322 may be fastened to the first rail 311 to be rotatable with regard to the bracket 310. The first rotating member 320 may rotate with regard to the bracket 310 together with the first rotating portion 322 as the first rotating portion 322 is fastened to the first rail 311. Likewise, the second rotating portion 332 may be fastened to the second rail 312 to be rotatable with regard to the bracket 310. The second rotating member 330 may rotate with regard to the bracket 310 together with the second rotating portion 332 as the second rotating portion 332 is fastened to the second rail 312.

According to various embodiments, the first rail 311 may include a first opening 311-1 and a first rotating guide (not shown). The first opening 311-1 may be formed in the bracket 310. In one embodiment, the first rotating guide may be a protruding portion formed toward the first opening 311-1. The first rotating guide may be fastened to a first rotating rail (not shown) formed at the first rotating portion 322. The first rotating guide and the first rotating rail may be formed in a corresponding shape to each other. For example, the first rotating guide and the first rotating rail may be formed in the shape of a circle in cross-section. The first rotating portion 322 may rotate with regard to the bracket 310 while the first rotating rail is inserted into the first rotating guide. The center M1 of the first rotating guide and the first rotating rail may be the rotating center M1 of the first rotating portion 322 rotating with regard to the bracket 310. The second rail 312 may include a second opening 312-1 and a second rotating guide (not shown). The second opening 312-1 may be formed in the bracket 310. In one embodiment, the second rotating guide may be a protruding portion formed toward the second opening 312-1. The second rotating guide may be fastened to a second rotating rail (not shown) formed at the second rotating portion 332. The second rotating guide and the second rotating rail may be formed in a shape corresponding to each other. For example, the second rotating guide and the second rotating rail may be formed in the shape of a circle in cross-section. The second rotating portion 332 may rotate with regard to the bracket 310 while the second rotating rail is inserted into the second rotating guide. The center M2 of the second rotating guide and the second rotating rail may be the rotating center of the second rotating portion 332 rotating with regard to the bracket 310.

According to various embodiments, the first rail 311 and the second rail 312 formed on the bracket 310 may be spaced apart from each other. For example, the first rail 311 and the second rail 312 may be formed on the bracket 310 so that they are positioned in opposite directions with regard to the center M of the bracket 310. **In** one embodiment, with reference to the side view of the hinge device 300 shown in FIG. 4b, the first rail 311 and the second rail 312 may at least partially overlap each other when viewed from a specific direction. Depending on where the first rail 311 and second rail 312 are formed, the first rotating portion 322 coupling the first rail 311 and the second rotating portion 332 coupling the second rail 312 may also be disposed at different locations. As the first rail 311 and the second rail 312 overlap each other when viewed from a specific direction, the first rotating portion 322 fastened to the first rail 311 and the second rotating portion 332 fastened to the second rail 312 may also at least partially overlap each other when viewed from a specific direction.

According to various embodiments, the first rotating member 320 and the second rotating member 330 may be fastened to the bracket 310 so that they can be rotated with regard to the bracket 310. The first rotating member 320 may include the first plate 321 and the first rotating portion 322. The second rotating member 330 may include the second plate 331 and the second rotating portion 332.

In one embodiment, the first plate 321 and the second plate 331 may support the display module 230. The display module 230 may include a first area, a second area, and a third area that is a folding area located between the first and second areas. The first, second and third areas are conceptually divided areas of the display module 230 for illustrative purposes and may not be visually separated areas. The first plate 321 may support the first area of the display module 230. The second plate 331 may support the second area of the display module 230. As the first plate 321 and the second plate 331 rotate with regard to bracket 310, the first and second areas of the display module 230 may also rotate with regard to bracket 310. When the first and second areas of the display module 230 are rotated, the first and second areas may be bent with regard to the third area.

In one embodiment, the first rotating portion 322 may be coupled to the first plate 321. For example, the first rotating portion 322 may be formed integrally with the first plate 321, and, in addition, the first rotating portion 322 may be coupled to the first plate 321 by various coupling methods (e.g., bolt coupling, rivet coupling, adhesive coupling, volumetric coupling). The second rotating portion 332 may be coupled to the second plate 331. For example, the second rotating portion 332 may be formed integrally with the second plate 331, and, in addition, the second rotating portion 332 may be coupled to the second plate 331 by various coupling methods.

As the first rotating portion 322 of the first rotating member 320 is rotatably fastened to the bracket 310, the first plate 321 may rotate with regard to the bracket 310. As the second rotating portion 332 of the second rotating member 330 is rotatably fastened to the bracket 310, the second plate 331 may rotate with regard to the bracket 310. The rotation of the first plate 321 with regard to bracket 310 may be accomplished with the center of the first rotating portion 322 as the rotating center M1. Hereinafter, the rotating center of the first plate 321 will be referred to as the first rotating center M1. The rotation of the second plate 331 with regard to bracket 310 may be accomplished with the center of the second rotating portion 332 as the rotating center M2. Hereinafter, the rotating center of the second plate 331 will be referred to as the second rotating center M2.

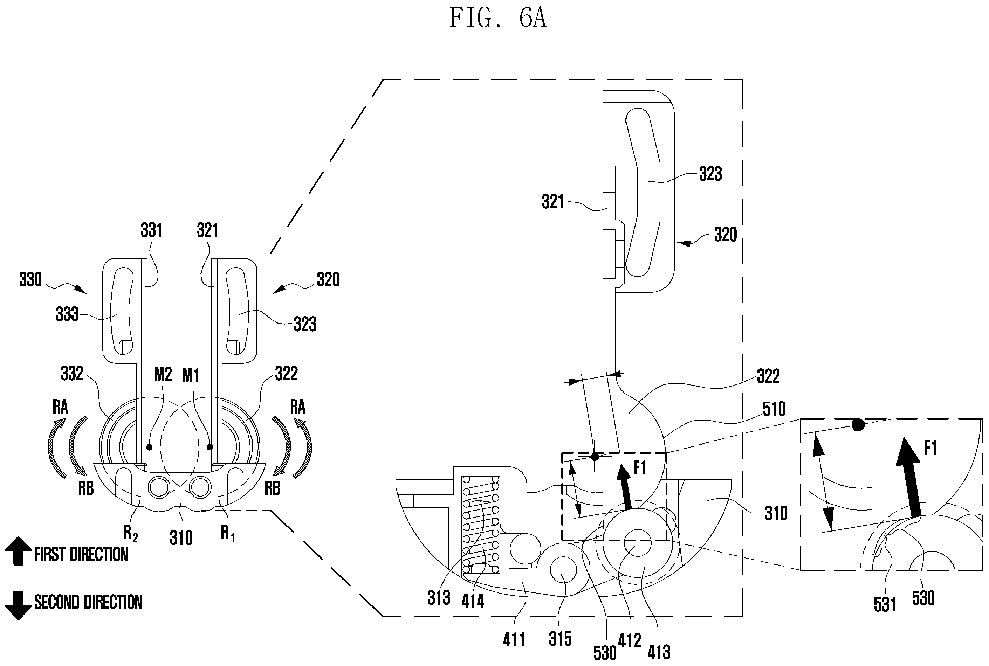

In one embodiment, with reference to FIG. 4c, the first rotating portion 322 and the second rotating portion 332 may be disposed in a bracket 310 so that the first rotating portion 322 and the second rotating portion 332 may partially overlap when viewed from one direction of the hinge device 300. For example, the first rotating member 322 and the second rotating portion 332 may be disposed in a bracket 310 so that the first rotating radius of the first rotating portion 322 (e.g., R1 of FIG. 6a) and the second rotating radius of the second rotating portion 332 (e.g., R2 of FIG. 6a) overlap each other.

The separation distance of the first rotating center M1 and the second rotating center M2 may be determined according to a folding curvature of the display module 230. Here, the folding curvature may mean a curvature at which the display module 230 can be stably folded. The folding curvature is a design specification of the display module 230 and may vary depending on the design of the display module 230. For example, the folding curvature may vary depending on the material constituting the display module 230 and the support structure of the display module 230. The rotation of the first rotating member 320 and the second rotating member 330 may be accomplished by rotation of the first rotating portion 322 and the second rotating portion 332 with regard to the bracket 310. The first rotating radius (e.g., R1 of FIG. 6a) of the first rotating portion 322 and the second rotating radius (e.g., R2 of FIG. 6a) of the second rotating portion 332 may be formed to be large so that the first rotating portion 322 and the second rotating portion 332 can be stably installed on the bracket 310. Since the separation distance between the first rotating center M1 and the second rotating center M2 is determined according to the folding curvature of the display module 230, making the first rotating radius R1 of the first rotating portion 322 and the second rotating radius R2 of the second rotating portion 332 larger may cause the first rotating radius R1 and the second rotating radius R2 to overlap each other. By causing a portion of the first rotating portion 322 and the second rotating portion 332 to overlap when the hinge device 300 is viewed from one direction, the first rotating radius R1 and the second rotating R2 may be formed as large as necessary.

According to the invention, as shown in FIG. 4c, a first limiting member 410 that limits rotation of the first rotating member 320 and a second limiting member 420 that limits rotation of the second rotating member 330, are disposed in the bracket 310. The first limiting member 410 includes a first body portion 411, a first contact portion 413, and a first pressurizing member 414 formed of an elastic material. The first contact portion 413 may be formed at one end of the first body portion 411 and may be in contact with the first rotating portion 322 of the first rotating member 320. The first contact portion 413 may be integrally formed with the first body portion 411, or may otherwise be coupled to the first side of the first body portion 411 in a variety of other ways (e.g., bolt coupling, rivet coupling, adhesive coupling, volumetric coupling). A first pressurizing member 414 may be disposed in the first seating portion 313 formed on the bracket 310 to pressurize an end of the first body portion 411. The second limiting member 420 includes a second body portion 421, a second contact portion 423, and a second pressurizing member 424 formed of an elastic material. The second contact portion 423 may be formed at one end of the second body portion 421 and may be in contact with the second rotating portion 332 of the second rotating member 330. The second contact portion 423 may be integrally formed with the second body portion 421, or may otherwise be coupled to the first end of the second body portion 421 in a variety of other ways (e.g., bolt coupling, rivet coupling, adhesive coupling, volumetric coupling). A second pressurizing member 424 may be disposed in the second seating portion 314 formed on the bracket 310 to pressurize an end of the second body portion 421.

According to various embodiments, the bracket 310 may have a first installation groove 317 formed in the bracket 310. The first limiting member 410 may be inserted into the bracket 310 through the first installation groove 317. The first installation groove 317 may be connected to a first rail 311 formed in the bracket 310. For example, the first installation groove 317 formed on one side of the bracket 310 may be connected to a first opening 311-1 formed on the other side of the bracket 310, which is the opposite side of the first side of the bracket 310. Accordingly, the first contact portion 413 of the first limiting member 410 disposed in the first installation groove 317 may be in contact with the first rotating portion 322 fastened in the first rail 311. Furthermore, a second installation groove 318 may be formed in the bracket 310. A second limiting member 420 may be inserted into the bracket 310 through the second installation groove 318. The second installation groove 318 may be connected to the second rail 312 formed in the bracket 310. For example, the second installation groove 318 formed on one side of the bracket 310 may be connected to a second opening 312-1 formed on the other side, which is the opposite side of the bracket 310. Accordingly, a second contact portion 423 of the second limiting member 420 disposed in the second installation groove 318 may contact a second rotating portion 332 fastened in the second rail 312.

According to the invention, the bracket 310 includes a shaft 315. The shaft 315 may be located in the center of the bracket 310. In one embodiment, the shaft 315 may be assembled integrally to bracket 310 and may be manufactured separately and coupled to bracket 310 in various ways (e.g., bolt coupling, rivet coupling, adhesive coupling, volumetric coupling). For example, with reference to FIG. 4c, the shaft 315 may be inserted into the insertion hole 316 formed on the bracket 310 and coupled to the bracket 310.

According to the invention, a first body portion 411 of the first limiting member 410 is inserted into the shaft 315 disposed on the bracket 310. For example, a first center hole 411-1 may be formed in the center of the first body portion 411. The first body portion 411 may be disposed on the bracket 310 so that the first center hole 411-1 is aligned with the insertion hole 316 in the bracket 310. The first body portion 411 may rotate with regard to the bracket 310 about the shaft 315 as the shaft 315 disposed on the bracket 310 is inserted into the first center hole 411-1 of the first body portion 411. The second body portion 421 of the second limiting member 420 is inserted into the shaft 315 disposed on the bracket 310. For example, a second center hole 421-1 may be formed in the center of the second body portion 421. The second body portion 421 may be disposed on the bracket 310 so that the second center hole 421-1 is aligned with the insertion hole 316 of the bracket 310. The second body portion 421 may rotate with regard to the bracket 310 about the shaft 315 as the shaft 315 disposed on the bracket 310 is inserted into the second center hole 421-1 of the second body portion 421. With reference to FIG. 4c, the shaft 315 may have a retaining member 401 coupled to the first limiting member 410 and the second limiting member 420 to maintain the first limiting member 410 inserted into the shaft 315.

In one embodiment, a first contact portion 413 of the first limiting member 410 may be provided at one end of the first body portion 411. The first contact portion 413 may be in contact with the first rotating portion 322 of the first rotating member 320. The first body portion 411 may rotate with regard to the bracket 310 about the shaft 315 in response to rotation of the first rotating member 320 as the first contact portion 413 contacts the first rotating portion 322. A second contact portion 423 of the second limiting member 420 may be provided at one end of the second body portion 421. The second contact portion 423 may contact the second rotating portion 332 of the second rotating member 330. The second body portion 421 may rotate with regard to the bracket 310 about the shaft 315 in response to rotation of the second rotating member 330 as the second contact portion 423 contacts the second rotating portion 332. The first contact portion 413 of the first limiting member 410 may provide force to the first rotating portion 322 by contacting the first rotating portion 322. The second contact portion 423 of the second limiting member 420 may provide force to the second rotating portion 332 by contacting the second rotating portion 332. The force provided by the first contact portion 413 and the second contact 423 may engage in an operation (hereinafter referred to as a "stopping operation") that causes the rotation of the first rotating portion 322 and the second rotating portion 332 to require a certain amount of external force. The frictional force between the first rotating portion 322 and the second rotating portion 332 and the first contact portion 413 and the second contact 423 may engage in an operation in which rotation of the hinge device 300 stops (hereinafter referred to as a "free-stop") in the absence of an externally provided force. This will be described in more detail later.

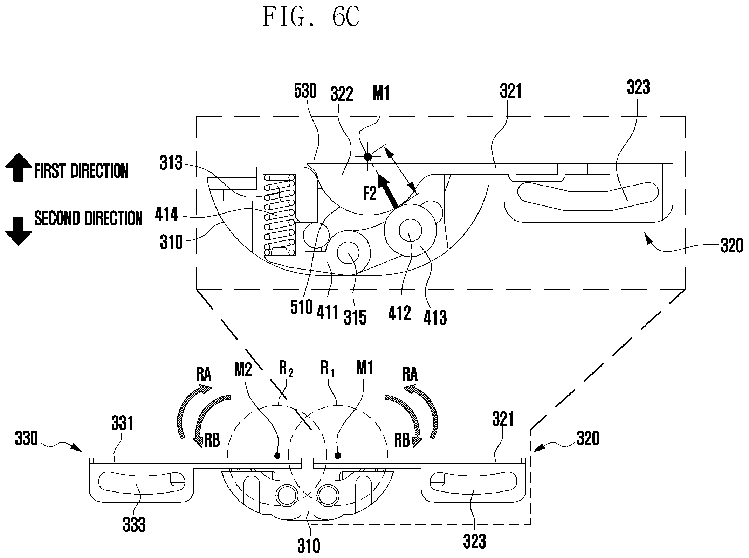

In one embodiment, a first pressurizing member 414 may be disposed in the first seating portion 313 formed on the bracket 310 to pressurize an end of the first body portion 411. As described above, the first body portion 411 may rotate about the shaft 315 of the bracket 310 in response to rotation of the first rotating member 320. The first pressurizing member 414 may pressurize an end of the first body portion 411 so that the contact between the first contact portion 413 and the first rotating portion 322 is maintained as the first body portion 411 rotates about the shaft 315. For example, with reference to FIGS. 6a and 6c which will be described later, in the case that the electronic device 200 transitions from an unfolded state to a folded state, the first body portion 411 may rotate counterclockwise (e.g., RA in FIG. 6a) about the shaft 315 as the first contact portion 413 contacts the first rotating portion 322. The first pressurizing member 414, which was compressed in the first direction in the unfolded state of the electronic device 200, may pressurize an end of the first body portion 411 in the second direction, which is the opposite direction of the first direction, by elastic restoring force as the first body portion 411 rotates counterclockwise. As the first pressurizing member 414 pressurizes the end of the first body portion 411, the contact between the first contact portion 413 and the first rotating portion 322 may be maintained, and the first contact portion 413 may provide a force to the first rotating portion 322. The force provided by the first contact portion 413 to the first rotating portion 322 may form a torque in the direction RA of folding the electronic device 200 about the first rotating center M1. Accordingly, a stopping operation may be implemented with the electronic device 200 in the folded state. This will be described in more detail later. (See FIG. 6a)

Conversely, in the case that the electronic device 200 transitions from a folded state to an unfolded state, the first body portion 411 may rotate clockwise (e.g., RB in FIG. 6a) about the shaft 315 as the first contact portion 413 contacts the first rotating portion 322. The first pressurizing member 414 may be compressed in the first direction as the first body portion 411 rotates in the clockwise direction (e.g., RB in FIG. 6a). In this case, the first pressurizing member 414 may pressurize an end of the first body portion 411 in the second direction, which is the opposite direction of the first direction, by elastic restoring force. As the first pressurizing member 414 pressurizes the end of the first body portion 411, the contact between the first contact portion 413 and the first rotating portion 322 may be maintained, and the first contact portion 413 may provide a force to the first rotating portion 322. In one embodiment, the force provided by the first contact portion 413 to the first rotating portion 322 may form a torque in the direction RB of the unfolding of the electronic device 200 about the first rotating center M1. Accordingly, a stopping operation may be implemented with the electronic device 200 in the unfolded state. This will be described in more detail later. (See FIG. 6c)

In one embodiment, a second pressurizing member 424 may be disposed in the second seating portion 314 formed in the bracket 310 to pressurize an end of the second body portion 421. As described above, the second body portion 421 may rotate about the shaft 315 of the bracket 310 in response to rotation of the second rotating member 330. The second pressurizing member 424 may pressurize an end of the second body portion 421 so that the contact between the second contact portion 423 and the second rotating portion 332 is maintained as the second body portion 421 rotates about the shaft 315. For example, with reference to FIGS. 6a and 6c which will be described later, in the case that the electronic device 200 transitions from an unfolded state to a folded state, the second body portion 421 may rotate clockwise (e.g., RA in FIG. 6a) about the shaft 315 as the second contact portion 423 contacts the second rotating portion 332. The second pressurizing member 424, which was compressed in the second direction in the unfolded state of the electronic device 200, may pressurize an end of the second body portion 421 in the second direction, which is the opposite direction of the first direction, by elastic restoring force as the second body portion 421 rotates clockwise. As the second pressurizing member 424 pressurizes the end of the second body portion 421, the contact between the second contact portion 423 and the second rotating portion 332 may be maintained, and the second contact portion 423 may provide a force to the second rotating portion 332. The force provided by the second contact 423 to the second rotating portion 332 may form a torque in the direction RA in which the electronic device 200 is folded with regard to the second rotating center M2. Accordingly, a stopping operation may be implemented in the folded state of the electronic device 200. This will be described in more detail later. (See FIG. 6a)

Conversely, in the case that the electronic device 200 transitions from a folded state to an unfolded state, the second body portion 421 may rotate in a counterclockwise direction (e.g., RB in FIG. 6a) about the shaft 315 as the second contact portion 423 contacts the second rotating portion 332. The second pressurizing member 424 may be compressed in the first direction as the second body portion 421 rotates in the counterclockwise direction (e.g., RB in FIG. 6a). In this case, the second pressurizing member 424 may pressurize the end of the second body portion 421 in the second direction, which is the opposite direction of the first direction, by elastic restoring force. As the second pressurizing member 424 pressurizes the end of the second body portion 421, the contact between the second contact portion 423 and the second rotating portion 332 may be maintained, and the second contact portion 423 may provide a force to the second rotating portion 332. In one embodiment, the force provided by the second contact 423 to the second rotating portion 332 may form a torque in the direction RB of the unfolding of the electronic device 200 about the second rotating center M2. Accordingly, a stopping operation may be implemented with the electronic device 200 in the unfolded state. This will be described in more detail later. (See FIG. 6c)

In one embodiment, the first pressurizing member 414 and the second pressurizing member 424 may be formed of an elastic material and may be formed in various shapes. For example, the first pressurizing member 414 and the second pressurizing member 424 may be manufactured in the form of a plural-winding spring, as shown in FIG. 4c. In addition, the first pressurizing member 414 and the second pressurizing member 424 may be formed in shape such as a leaf spring and may be formed from materials such as rubber, urethane and POM.

In one embodiment, the first contact portion 413 may be rotatable with regard to the first body portion 411. With reference to FIG. 4c, a first connecting shaft 412, into which the first contact portion 413 is inserted, may be formed at one end of the first body portion 411. The first contact portion 413 may be inserted into the first connecting shaft 412 and rotatable with regard to the first body portion 411. The first contact portion 413 may rotate with regard to the first body portion 411 about the first connection axis 412 by contacting the first rotating portion 322. In this case, a rolling friction may act between the first rotating portion 322 and the first contact portion 413. The rolling friction is less than the sliding friction that occurs when the first contact portion 413 slides against the first rotating portion 322 in a state that the first rotating portion 322 is not rotating with regard to the first body portion 411. Accordingly, the friction between the first rotating portion 322 and the first contact portion 413 is reduced, and the first rotating portion 322 and the first contact portion 413 may experience less wear due to contact. Further, as the friction between the first contact portion 413 and the first rotating portion 322 is reduced, the loss of driving force transmitted from the drive device 430 to the hinge device 300 may be alleviated.

In one embodiment, the second contact portion 423 may be rotatable with regard to the second body portion 421. With reference to FIG. 4c, a second connecting shaft 422, into which the second contact portion 423 is inserted, may be formed at one end of the second body portion 421. The second contact portion 423 may be inserted into the second connecting shaft 422 and rotatable with regard to the second body portion 421. The second contact portion 423 may rotate with regard to the second body portion 421 about the second connection axis 422 by contacting the second rotating portion 332. In this case, a rolling friction may act between the second rotating portion 332 and the second contact portion 423. The rolling friction is less than the sliding friction that occurs when the second contact portion 423 slides against the second rotating portion 332 in a state that the second contact portion 423 is not rotating about the second body portion 421. Accordingly, the friction between the first rotating portion 322 and the first contact portion 413 is reduced, and the first rotating portion 322 and the first contact portion 413 may experience less wear due to contact. Further, as the friction between the second contact portion 423 and the second rotating portion 332 is reduced, the loss of driving force transmitted from the drive device 430 to the hinge device 300 may be alleviated.

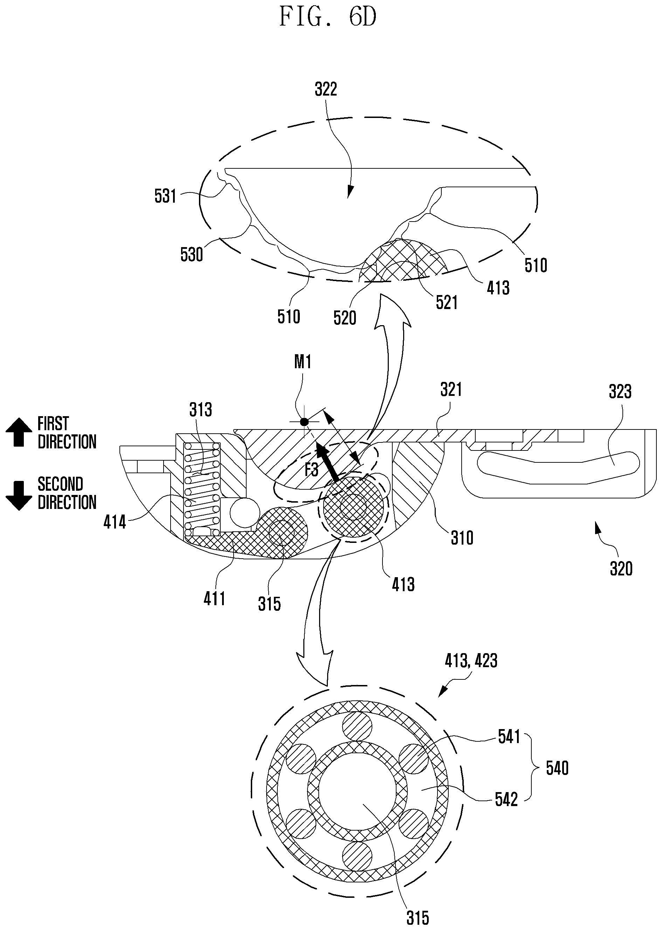

In one embodiment, the first contact portion 413 and the second contact portion 423 may include a bearing member 540. The first contact portion 413 and the second contact portion 423 may rotate with regard to the first body portion 411 through the bearing member 540. For example, the bearing member 540 may be inserted rotatably about the first connecting shaft 412 of the first body portion 411 and the second connecting shaft 422 of the second body portion 421, respectively. In one embodiment, with reference to FIG. 6d, which will be described later, the bearing member 540 may include a ball receiving portion 542 and a ball 541 that is seated in the ball receiving portion 542. The first contact portion 413 and the second contact portion 423, according to various embodiments disclosed in this document, may include the bearing member 540. The bearing member 540 may reduce friction between the first contact portion 413 and the first connecting shaft 412, friction between the first contact portion 413 and the first rotating portion 322, friction between the second contact portion 423 and the second connecting shaft 422, and friction between the second contact portion 423 and the second rotating portion 332.

According to various embodiments, the first arm 340 may be rotatably installed with regard to the bracket 310. With reference to FIG. 4c, a fixed housing 440 may be disposed in the electronic device 200 to fix the drive device 430 to the first housing 210 or the second housing 220. The drive device 430 may be disposed in the fixed housing 440 and be fixed within the electronic device 200. The first arm 340 may be rotatable with regard to the bracket 310 in connection with the drive device 430 disposed in the fixed housing 440. In one embodiment, the first arm 340 may include a first gear 341. The first gear 341 may be integrally formed with the first arm 340 or may be manufactured separately. The first gear 341 may be coupled to the first arm 340 and rotate with the first arm 340 with regard to the bracket 310. The first gear 341 may be coupled to the drive shaft 431 of the drive device 430, and may rotate with regard to the bracket 310 according to the operation of the drive device 430. This will be described in more detail later. The second arm 350 may be rotatably installed with regard to the bracket 310. The second arm 350 may include a shaft 352 that couples the second arm 350 to the fixed housing 440. In one embodiment, the second arm 350 may include a second gear 351 connected to the shaft 352. With reference to FIG. 4c, a second gear 351 - a second arm 350 - a fixed housing 440 may be inserted into the shaft 352. In another embodiments, the second gear 351 may be formed integrally with the second arm 350.

In one embodiment, between the first gear 341 of the first arm 340 and the second gear 351 of the second arm 350, an interworking gear 380 coupling the first gear 341 and the second gear 351 may be disposed. The interworking gear 380 may interwork the rotation of the first arm 340 and the second arm 350 to the bracket 310. In one embodiment, the drive shaft 431 of the drive device 430 may be inserted into at least one of the first gear 341, the second gear 351 and the interworking gear 380. The gear coupled to the drive shaft 431 of the drive device 430 may rotate with regard to the bracket 310 as the drive device 430 operates. Hereinafter, for the convenience of explanation, description will be made on the assumption that the first gear 341 is connected to the drive shaft 431.

In one embodiment, the interworking gear 380 may interwork the rotation of the first arm 340 and the second arm 350 with regard to the bracket 310. The first arm 340 and the second arm 350 may be interworked with each other by the interworking gear 380 and may rotate with regard to the bracket 310. By the interworking gear 380, the first arm 340 and the second arm 350 may be interworked to rotate in opposite directions. The first arm 340 and the second arm 350 may rotate together in a direction in which the electronic device 200 is unfolded or folded. The interworking gear 380 may include a plurality of gears, for example, as shown in FIGS. 4a to 4c. The plurality of gears included in the interworking gear 380 may be an even number to allow the first arm 340 and the second arm 350 to interwork and rotate in opposite directions. Some of the plurality of gears may be coupled to the fixed housing 440. For example, the interworking gear 380 may include an interworking shaft. With reference to FIG. 4c, the interworking gear 380 may include a first interworking gear 381 including a first interworking shaft 381A and a second interworking gear 382 including a second interworking shaft 382A. The first interworking gear 381 may be fastened to the fixed housing 440 as the first interworking shaft 381A is inserted into the fixed housing 440. The second interworking gear 382 may be fastened to the fixed housing 440 as the second interworking shaft 382A is inserted into the fixed housing 440. The first interworking gear 381 may mesh with the first gear 341 of the first arm 340 and the second interworking gear 382, and the second interworking gear 382 may mesh with the first interworking gear 381 and the second gear 351 of the second arm 350. Accordingly, in the case that the first gear 341 connected to the drive shaft 431 rotates in response to operation of the drive device 430, the driving force of the drive device 430 may be transmitted in the order of the first gear 341 - the first interworking gear 381 - the second interworking gear 382 - the second gear 351. The interworking gear 380 has been described above. However, the above description is not meant to limit the number of interworking gears 380. The number of interworking gears 380 may be varied in consideration of the size of the hinge device 300 and the number required to operate the hinge device 300.

In one embodiment, with reference to FIG. 5, a drive shaft 431 of the drive device 430 may be inserted into the first arm 340 and the first gear 341. The drive device 430 may include a plurality of friction plates 432 and 433 connected to the drive shaft 431. The friction plates 432 and 433 may include a first friction plate 432 pressurizing the first arm 340 and a second friction plate 433 pressurizing the first gear 341. With reference to FIG. 5, the first friction plate 432 - first arm 340 - first gear 341 - second friction plate 433 may be inserted into the drive shaft 431 in this order. At one end of the drive shaft 431 may be disposed a first pressurizing plate 434 that pressurizes the first friction plate 432. The first friction plate 432 may be disposed between the first pressurizing plate 434 and the first arm 340 and may be in contact with the first pressurizing plate 434 and the first arm 340. As the first pressurizing plate 434 pressurizes the first friction plate 432, the first friction plate 432 may be joined tightly with the first arm 340 to pressurize the first arm 340. At the end of the drive shaft 431, a second pressurizing plate 435 pressurizing the second friction plate 433 - an elastic member 437 pressurizing the second pressurizing plate 435 - and a tightening member 436 (e.g., a nut) pressurizing the elastic member 437 may be disposed. The second friction plate 433 may be disposed between the second pressurizing plate 435 and the first gear 341, and may be in contact with the second pressurizing plate 435 and the first gear 341. In one embodiment, a tightening member 436 (e.g., a nut) disposed at an end of the drive shaft 431 may be manipulated so that the second friction plate 433 pressurizes the first gear 341. The friction force between the first gear 341 and the second friction plate 433 may be adjusted by manipulating the tightening member. For example, tightening the tightening member 436 may increase the friction force between the first gear 341 and the second friction plate 433 as a result of the elastic member 437 compressurizing the second friction plate 433. Conversely, in the case that the tightening member 436 is loosened, the elastic member 437 may pressurize the second friction plate 433 relatively less than in the case that the tightening member 436 is tightened. As a result, the friction force between the first gear 341 and the second friction plate 433 may be reduced. Accordingly, the friction force between the second friction plate 433 and the first gear 341 may be adjusted by manipulating the tightening member 436.

The drive device 430, according to various embodiments disclosed in this document, may be electrically connected to a processor (e.g., the processor 120 of FIG. 1). The processor may control operation of the drive device 430 in response to external inputs. As the drive shaft 431 of the drive device 430 rotates, the first friction plate 432 and the second friction plate 433 connected to the drive shaft 431 may rotate. The first friction plate 432 and the second friction plate 433 may contact the first arm 340 and the first gear 341, respectively, to transmit the driving force of the drive device 430 to the first arm 340 and the first gear 341. Accordingly, the first arm 340 and the first gear 341 may rotate with regard to the bracket 310 through contact with the first friction plate 432 and the second friction plate 433. The first arm and the second arm may be interworked with each other through an interworking gear 380 disposed between the first gear 341 and the second gear 351. Accordingly, the first arm 340 and the second arm 350 may rotate in opposite directions from each other through the interworking gear 380, and the first rotating member 320 connected to the first arm 340 through the first pin 360 and the second rotating member 330 connected to the second arm 350 through the second pin 370 may also rotate in opposite directions from each other.

On the other hand, in the case that a certain level of torque or more is applied to the hinge device 300, the first friction plate 432 may slip with regard to the first arm 340, and the second friction plate 433 may slip with regard to the first gear 341. Accordingly, damage to the hinge device 300 and the connected drive device 430 may be prevented.

According to various embodiments, the first arm 340 and the first rotating member 320 may be connected by a first pin 360. The first arm 340 and the first rotating member 320 connected to the first pin 360 may rotate together with regard to the bracket 310. With reference to FIG. 4b, the third rotating center M3 of the first arm 340 and the first rotating center M1 of the first rotating member 320 may be disposed at different positions. Accordingly, the rotational trajectories of the first arm 340 and the first rotating member 320 may differ. To compensate for this difference, a first pin 360 may be inserted into a first compensation rail 323 formed in the first rotating member 320. The first compensation rail 323 may be formed extending in one direction with regard to the first plate 321. During rotation of the first arm 340 and the first rotating member 320, the first pin 360 may move along the first compensation rail 323. The second arm 350 and the second rotating member 330 may be connected by a second pin 370. The second arm 350 and the second rotating member 330 connected to the second pin 370 may rotate together with regard to bracket 310. With reference to FIG. 4b, the fourth rotating center M4 of the second arm 350 and the second rotating center M2 of the second rotating member 330 may be disposed at different locations. Accordingly, the rotational trajectories of the second arm 350 and the second rotating member 330 may differ. To compensate for this difference, a second pin 370 may be inserted into a second compensation rail 333 formed in the second rotating member 330. The second compensation rail 333 may be formed extending in one direction with regard to the second plate 331. During rotation of the second arm 350 and the second rotating member 330, the second pin 370 may move along the second compensation rail 333. Since the first arm 340 and the first rotating member 320 are connected and rotate together, and the second arm 350 and the second rotating member 330 are connected and rotate together, the rotation of the first rotating member 320 and the second rotating member 330 may also be interworked by an interworking gear 380 that interworks the first arm 340 and the second arm 350. The interworking gear 380 may interwork the rotation of the first rotating member 320 and the second rotating member 330 so that the first rotating member 320 and the second rotating member 330 can rotate in opposite directions to each other. With reference to FIG. 4c, the ends of the first pin 360 and the second pin 370 may each have a retaining member 401 fastened therewith to allow the first rotating member 320 and the first arm 340 to remain inserted into the first pin 360, and the second body portion 421 and the second arm 350 to remain inserted by the second pin 370.

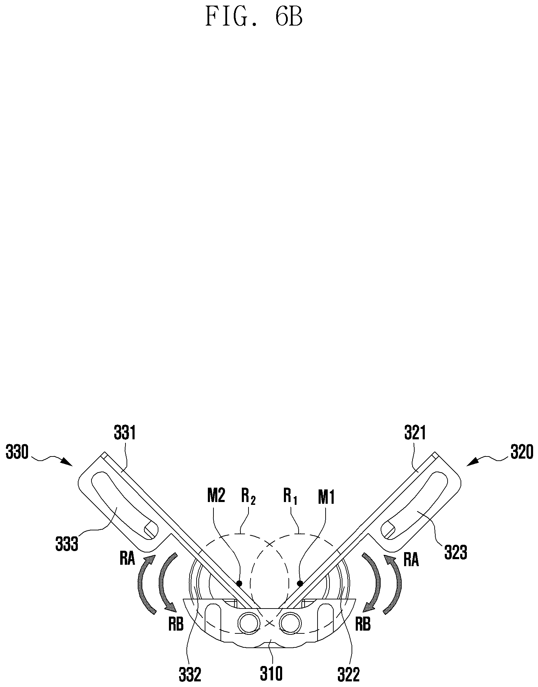

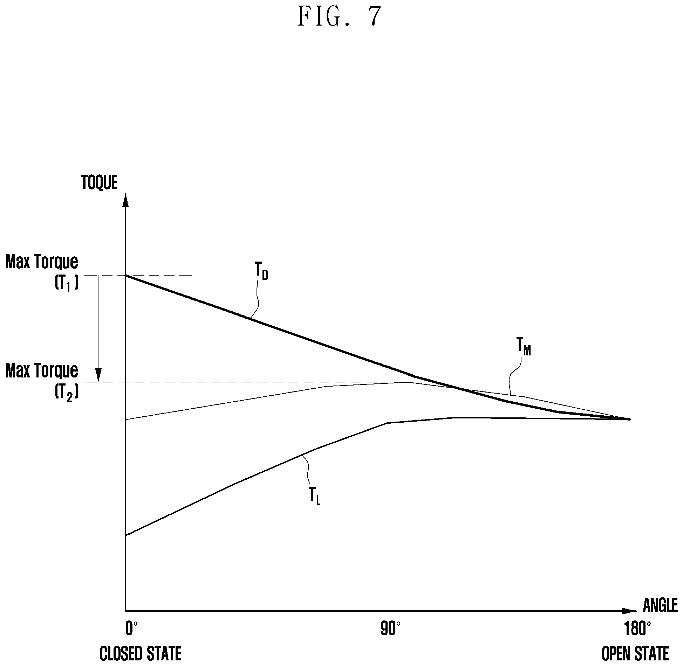

FIG. 6a is a diagram explaining the operation of the hinge device when the electronic device is in a folded state. FIG. 6b is a diagram explaining the operation of the hinge device when the electronic device is in an intermediate state. FIG. 6c is a diagram explaining the operation of the hinge device when the electronic device is in an unfolded state. FIG. 6d is a diagram illustrating a state in which a roller of a limiting member is in contact with a stop portion concavely formed in a rotating portion of a hinge device when the electronic device is in an unfolded state. FIG. 7 is a diagram illustrating the torque generated by the display module, the torque generated by the transmission device, and the torque generated by the limiting member.

In the following description, the first rotating portion 322 will be used to describe the rotating portion. The second rotating portion 332 is a corresponding configuration to the first rotating portion 322, and the description of the "first rotating portion 322" in the following description may be equally applied to the "second rotating portion 332". In addition, in describing the limiting members (first limiting member 410, second limiting member 420), the first limiting member 410 will be used for explanation. The second limiting member 420 is a counterpart configuration to the first limiting member 410, and the description of the "first limiting member 410" in the following description may be equally applied to the "second limiting member 420".

According to various embodiments, as shown in FIGS. 6a to 6d, the first rotating portion 322 may include a circular portion 510 in which the cross-section is circular, a stop portion 520 formed concave in the circular portion 510, and an end portion 530 that extends from the circular portion 510 and is circular in cross-section. In one embodiment, the curvature of the circular portion 510, the stop portion 520 and the end portion 530 are different from each other, and the center of curvature may also be different.

According to various embodiments, the first rotating portion 322 may include a stoppers 521 and 531 that limits the movement of the first contact portion 413 so that the electronic device 200 does not unfold or fold beyond a certain level. In one embodiment, the stop portion 520 and the end portion 530 may include the first stopper 521 and the second stopper 531, respectively. The first stopper 521 may be formed at one end of the stop portion 520 and protrude from the stop portion 520. The first stopper 521 may restrict the movement of the first rotating portion 322 with regard to the first contact portion 413 so that the electronic device 200 does not unfold beyond a certain level. The second stopper 531 may be formed to protrude from one end of the end portion 530. The second stopper 531 may limit the movement of the first rotating portion 322 with regard to the first contact portion 413 so that the electronic device 200 does not fold beyond a certain level.

According to various embodiments, as shown in FIGS. 6a to 6d, the cross-section of the first rotating member 322 may be in the shape of a circle, but not in the shape of a complete circle, but as part of a circle. Accordingly, in the process of rotation of the first rotating portion 322, the position of contact with the first contact portion 413 of the first limiting member 410 may be varied. For example, depending on the degree of rotation of the first rotating portion 322, at least one of the circular portion 510, the end portion 530 and the stop portion 520 of the first rotating portion 322 may be contacted with the first contact portion 413. When the electronic device 200 is in the folded state, when the electronic device 200 is in the unfolded state, and when the electronic device 200 is in the intermediate state, the contact positions of the first rotating portion 322 and the first contact portion 413 may be different.

According to various embodiments, a stopping operation and a free-stop operation may be required to increase the usability of the electronic device 200. A stopping operation may mean an operation of maintaining the electronic device 200 in a fully folded or fully unfolded state. A free-stop operation may mean an operation that an electronic device maintains its state when no external force exceeding a certain level is applied in the process of transitioning from a folded state to an unfolded state. The stopping operation and the free-stop operation may be implemented by providing a torque TD that is greater than the sum of the torque generated in the direction RB in which the display module 230 is to be unfolded as the display module 230 is folded and the torque due to gravity acting on the hinge device 300 configuration. In one embodiment, the stopping operation and the free-stop operation may be implemented by utilizing a stopping torque generated by the drive shaft 431 of the drive device 430 not rotating and/or a torque generated through a force provided by the first contact portion 413 of the first limiting member 410 to the first rotating portion 322. Here, the stopping torque may be a torque provided by the drive device 430 that is generated by a stopping force that attempts to maintain the current state of the drive shaft 431 as the operation of the drive device 430 stops. For example, if the drive device 430 is stopped and a torque is generated on the drive shaft 431 in the direction RB in which the electronic device 200 is intended to unfold, the stopping force of the drive device 430 may generate a stopping torque in the direction RA opposite to the direction RB in which the electronic device 200 is intended to unfold. Conversely, in the case that a torque in the direction RA in which the electronic device 200 is to be folded is generated on the drive shaft 431 while the drive device 430 is stopped, a stopping torque in the direction RB opposite to the direction RA in which the electronic device 200 is to be folded may be generated.

In one embodiment, the first contact portion 413 may pressurize the end portion 530 of the first rotating portion 322 when the electronic device 200 is in the folded state. The force provided by the first contact portion 413 to the end portion 530 may form a torque in a direction opposite to the direction RB in which the electronic device 200 is to be unfold, thereby implementing a stopping operation. In one embodiment, the first contact portion 413 may implement the stopping operation by pressurizing the stop portion 520 of the first rotating portion 322 when the electronic device 200 is in the unfolded state. The force provided by the first contact portion 413 to the stop portion 520 may form a torque in a direction opposite to the direction RA in which the electronic device 200 is be folded, thereby implementing a stopping operation. In one embodiment, the first contact portion 413 may implement a free-stop operation by pressurizing the circular portion 510 of the first rotating portion 322 when the electronic device 200 is in an intermediate state. The force provided by the first contact portion 413 on the circular portion 510 may form a torque in the opposite direction from the direction in which the electronic device 200 is to move, thereby implementing a free-stop operation. Accordingly, the stopping operation and the free-stop operation may be implemented using the torque generated by the stopping torque of the drive device 430 and/or the force provided by the first contact portion 413 of the first limiting member 410 to the first rotating portion 322.

According to various embodiments, stopping the electronic device 200 in the closed state may be implemented through the drive device 430. A processor connected to the drive device 430 (e.g., the processor 120 of FIG. 1) may determine whether the electronic device 200 is in a closed state through the first Hall sensor 610 disposed on the electronic device 200. For example, in the case that the electronic device 200 is in a closed state, the first Hall sensor 610 disposed at an end of the first housing 210 and the first magnetic member 611 disposed at an end of the second housing 220 may be adjacent (see FIG. 3b). A memory of the electronic device 200 (e.g., the memory 130 of FIG. 1) may pre-store a value measuring a change in magnetic field as a function of distance between the first Hall sensor 610 and the first magnet member 611. The processor may use the value pre-stored in the memory to determine whether the electronic device 200 is in a closed state. In the case that the electronic device 200 is in the closed state, the processor may stop operation of the drive device 430.

In one embodiment, when the electronic device 200 is in a folded state, the drive device 430 may provide a torque TM of the opposite direction RA that is greater in magnitude than the torque in which the electronic device 200 rotates in the direction RB in which it is to unfold in the folded state. For example, the display module 230 may form a torque TD in the direction in which it is to unfold RB. The stopping force of the drive device 430 is greater than the rotational torque TD in the direction RB in which the display module 230 is to unfold and may form a torque TM in the opposite direction RA. Accordingly, the electronic device 200 may maintain the closed state through the drive device 430.

In one embodiment, the stopping by the drive device 430 when the electronic device 200 is in the folded state may be assisted by the first limiting member 410. When the electronic device 200 is in the folded state, the display module 230 may generate a torque TD in the direction RB to be unfolded. With reference to FIG. 6a, when the electronic device 200 is in the folded state, the first contact portion 413 of the first limiting member 410 may be in contact with the end portion 530 of the first rotating portion 322. The force F1 provided by the first contact portion 413 to the end portion 530 may provide a torque TL that can rotate the first rotating portion 322 in a direction RA opposite of the direction RB in which the electronic device 200 is to be unfolded. The torque TL generated by the first limiting member 410 may offset the torque TD generated by the display module 230 or may reduce the magnitude of the torque TD generated by the display module 230. Accordingly, the drive device 430 may implement a stopping operation of the electronic device 200 by providing a torque TM corresponding to the torque T2 (see FIG. 7) remaining after the torque TD generated by the display module 230 and the torque TL generated by the first limiting member 410 are offset. The torque TL provided by the first limiting member 410 may be proportional to the diameter of the first rotating portion 322 and the force F1 exerted by the first contact portion 413 on the first rotating portion 322. Accordingly, by adjusting the diameter of the first rotating portion 322 and the force F1 exerted by the first contact portion 413 on the first rotating portion 322, the torque TM of the drive device 430 required to maintain the stopping operation of the electronic device 200 may be adjusted. As the stopping operation is assisted by the first limiting member 410, the torque TM of the drive device 430 required for the stopping operation may be reduced.

With reference to FIG. 6b, in one embodiment, when the electronic device 200 is in an intermediate state, the first contact portion 413 of the first limiting member 410 may be contacted with the circular portion 510 of the first rotating portion 322. The force provided by the first contact portion 413 to the circular portion 510 may be achieved by forming a torque in the direction opposite to the direction in which the electronic device 200 is to move, thereby implementing a free-stop operation.

In one embodiment, in the case that the first contact portion 413 does not rotate with regard to the first body portion 411, a frictional force may be exerted between the first contact portion 413 and the first rotating portion 322. The frictional force may increase in size as the first contact portion 413 pressurizes the circular portion 510 strongly. The rotation of the first rotating portion 322 may be obstructed by frictional forces acting between the first contact portion 413 and the circular portion 510. For example, frictional forces may form torque in the opposite direction to the direction in which the electronic device 200 is to move. In the case that no force is provided in excess of the frictional force, the rotation of the first rotating member 322 may remain stationary. Accordingly, a free-stop operation may be implemented in the electronic device 200.

In one embodiment, as described above, the first contact portion 413 is inserted into the first connecting shaft 412 of the first body portion 411 and is rotatable about the first body portion 411. The first contact portion 413 may be rotated with regard to the first body portion 411 by contact with the first rotating portion 322 when the electronic device 200 transitions from an unfolded state to a folded state or from a folded state to an unfolded state. Accordingly, as the rolling friction acts between the first contact portion 413 and the first rotating portion 322, the free-stop operation may not be implemented only by friction force. In this case, the free-stop may be implemented through a drive device 430 connected to the hinge device 300. In one embodiment, the drive device 430 may be electrically coupled to a processor. The processor may control the drive device 430 to stop operating in response to an external input. For example, the processor may control the operation of the drive device 430 to stop in an intermediate state between the unfolded state and the folded state of the electronic device 200 according to the external input. The stopping force of the drive device 430 generated by stopping of the drive device 430 may form a torque TM that is opposite in direction so that the torque in the direction RB of the electronic device 200 to be unfolded or the torque in the direction RA of the electronic device 200 to be closed is canceled out. For example, the drive device 430 may provide a torque TM in the direction RA that offsets the torque TD in the direction RB in which the display module 230 is to be unfolded. Accordingly, the electronic device 200 may implement a free-stop operation in which the electronic device 200 stops at a specific angle through the drive device 430.

In one embodiment, the free-stop operation by the drive device 430 may be assisted by the first limiting member 410. For example, when the electronic device 200 is in an intermediate state, the display module 230 may generate a torque TD in the direction RB to unfold upon folding. The force provided by the first contact portion 413 to the first rotating portion 322 may provide a torque TL that can rotate the first rotating portion 322 in a direction RA opposite of the direction RB in which the electronic device 200 is to be unfolded. The torque TL generated by the first limiting member 410 may offset the torque TD generated by the display module 230 or may reduce the magnitude of the torque TD generated by the display module 230. Accordingly, the drive device 430 may implement the free-stop operation of the electronic device 200 by providing a torque TM corresponding to the torque T2 (see FIG. 7) remaining after the torque TD generated by the display module 230 and the torque TL generated by the first limiting member 410 are offset. As the free-stop operation is assisted by the first limiting member 410, the torque TM of the drive device 430 required for the free-stop operation may be reduced.

According to various embodiments, the operation of stopping the electronic device 200 in the unfolded state may be implemented through the drive device 430. As described above, a processor connected to the drive device 430 may determine that the electronic device 200 is in the unfolded state through a second Hall sensor 620 disposed at a hinged portion of the electronic device 200. For example, the first housing 210 may include a second Hall sensor 620 disposed adjacent to the hinge device 300, and the second housing 220 may include a second magnetic member 621 disposed adjacent to the hinge device 300. The second Hall sensor 620 and the second magnetic member 621 may be disposed in the first housing 210 and the second housing 220, respectively, so that the electronic device 200 is adjacent in the unfolded state (see FIG. 3b). A memory of the electronic device 200 may pre-store a value measuring a change in magnetic field as a function of distance between the second Hall sensor 620 and the second magnetic member 621. The processor may use the pre-stored value in the memory to determine whether the electronic device 200 is in the unfolded state. In the case that the electronic device 200 is in the unfolded state, the processor may stop operation of the drive device 430. The stopping force of the drive device 430 may form a torque TM that is greater than the torque that rotates the electronic device 200 in the direction RA in which the electronic device 200 is to be folded from the unfolded state and is in the opposite direction RB. Accordingly, the electronic device 200 may be maintained in the unfolded state through the drive device 430.

With reference to FIG. 6c, in one embodiment, when the electronic device 200 is in the unfolded state, the unfolded state by the drive device 430 may be assisted by the first limiting member 410. When the electronic device 200 is in the unfolded state, the first contact portion 413 may be in contact with the circular portion 510 of the first rotating portion 322. In one embodiment, the force F2 provided by the first contact portion 413 to the circular portion 510 may provide a torque that can rotate the first rotating portion 322 in a clockwise direction RB. For example, the direction of the force F2 applied by the first rotating portion 322 to the circular portion 510 may be prevented from pointing towards the first rotation center M1 of the first rotating portion 322 by adjusting the diameter of the first rotating portion 322, the contact point between the first rotating portion 322 and the circular portion 510, etc. Accordingly, as the stopping operation of the electronic device 200 is assisted by the torque TL generated by the first limiting member 410, the torque TM of the drive device 430 required for the stopping operation may be reduced. In another embodiment, with reference to FIG. 6c, the direction of the force F2 that the first contact portion 413 provides to the circular portion 510 of the first rotating portion 322 may be toward the first rotating center M1 of the first rotating portion 322. Accordingly, the force F2 provided by the first contact portion 413 to the circular portion 510 may not generate a torque on the first rotating portion 322. In this case, the stopping operation of the electronic device 200 in the unfolded state may be realized through the torque TM generated by the drive device 430.

With reference to FIG. 6d, in one embodiment, when the electronic device 200 is in the unfolded state, the first contact portion 413 may contact a stop portion 520 of the first rotating portion 322. The stop portion 520 may be a concave portion of the first rotating portion 322. In one embodiment, the force F3 provided by the first contact portion 413 to the end portion 530 may provide a torque that can rotate the first rotating portion 322 in a clockwise direction RB. For example, the direction of the force F3 applied by the first rotating portion 322 to the stop portion 520 may be prevented from pointing towards the first rotation center M1 of the first rotating portion 322 by adjusting the diameter of the first rotating portion 322, the contact point between the first rotating portion 322 and the stop portion 520, etc. Accordingly, the force F3 provided by the first contact portion 413 to the stop portion 520 may provide a torque that allows the electronic device 200 to rotate the first rotating portion 322 in the opening direction RB. Accordingly, as the stopping operation of the electronic device 200 is assisted by the torque TL generated by the first limiting member 410, the torque TM of the drive device 430 required for the stopping operation may be reduced. In another embodiment, with reference to FIG. 6d, the direction of the force F3 provided by the first contact portion 413 to the stop portion 520 may be directed toward the first rotating center M1 of the first rotating portion 322. Accordingly, the torque caused by the force F3 provided by the first contact portion 413 to the stop portion 520 may not be generated on the first rotating portion 322. In this case, the stopping operation of the electronic device 200 in the unfolded state may be implemented through the torque TM generated by the drive device 430.

The first limiting member 410, according to various embodiments disclosed in this document, may assist the driving force of the drive device 430 required to implement a stopping operation and a free-stop operation. With reference to FIG. 7, it can be seen that the torque TD generated as the display module 230 is folded is maximum in the folded state of the electronic device 200 (e.g., 0 degree in FIG. 7) with the display module 230 maximally folded, and is minimum in the unfolded state of the electronic device 200 (e.g., 180 degrees in FIG. 7). The first limiting member 410 may form a torque TL in a direction RA opposite to the torque TD in the direction RB in which the display module 230 is to be unfolded when the display module 230 is folded to a certain angle or less. Accordingly, the maximum torque T1 formed by the display module 230 when the electronic device 200 is in the folded state may be offset by the torque TL formed by the first limiting member. The drive device 430 may provide a torque TM corresponding to the torque T2 remaining after the torque TD generated by the display module 230 and the torque TL generated by the first limiting member 410 are offset, thereby implementing a stopping operation or a free-stop operation. In various embodiments disclosed in this document, the load on the drive device 430 may be reduced through the first limiting member 410 in implementing the stopping operation or the free-stop operation. Further, the torque TL formed by the first limiting member 410 may reduce the torque TM of the drive device 430 required for the stopping operation or the free-stop operation. Accordingly, the opening and closing of the electronic device 200 may be realized using a compact drive device 430 within a limited space of the electronic device 200.

According to various embodiments, the drive device 430 may include a reducer (not shown). The reducer may be a configuration that combines with the motor as the power source of the drive device 430 and reduces the output rotation of the motor so that a high torque can be obtained. The electronic device 200 according to the various embodiments disclosed in this document requires the drive device 430 to be disposed within a limited space, so that a miniaturized drive device 430 may be used. The drive device 430 disclosed in the present document may secure a certain level of torque required for the opening and closing of the electronic device 200 within a limited space by using a reducer.

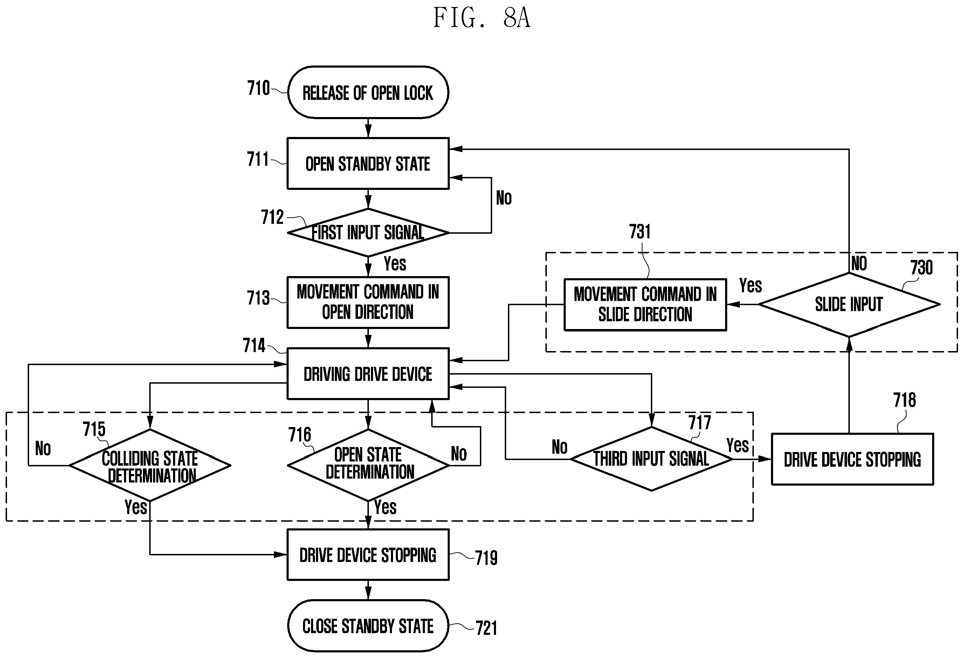

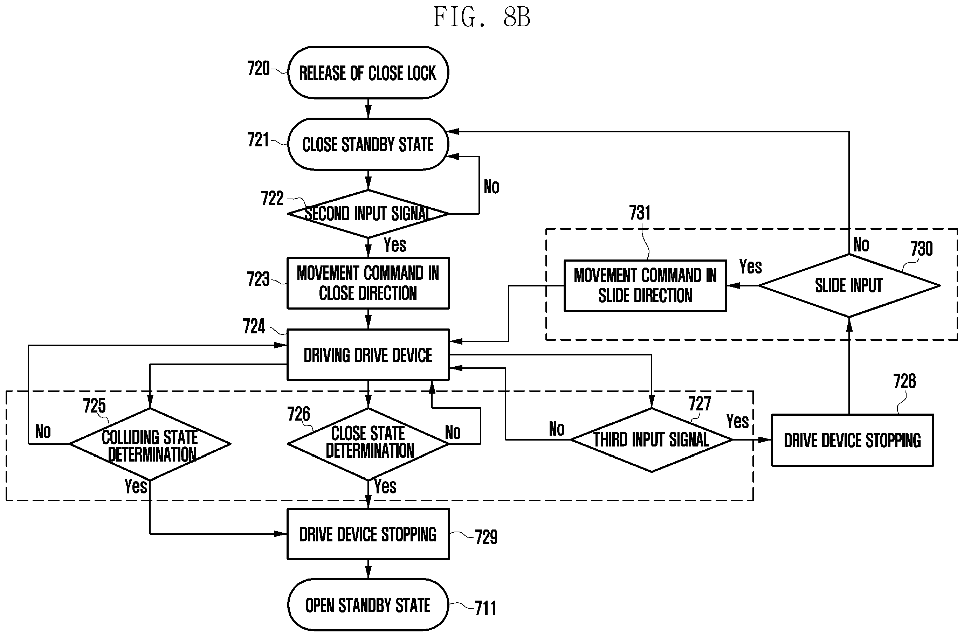

FIG. 8a is a processor flowchart for an unfolding operation of an electronic device. FIG. 8b is a processor flowchart for a folding operation of an electronic device.

According to various embodiments, a processor connected to the drive device 430 (e.g., the processor 120 of FIG. 1) may determine whether the electronic device 200 is in a closed state through the first Hall sensor 610 disposed on the electronic device 200. For example, in the case that the electronic device 200 is in a closed state, the first Hall sensor 610 disposed at an end of the first housing 210 and the first magnetic member 611 disposed at an end of the second housing 220 may be adjacent (see FIG. 3b). A memory of the electronic device 200 (e.g., the memory 130 of FIG. 1) may pre-store a value measuring a change in magnetic field as a function of distance between the first Hall sensor 610 and the first magnet member 611. The processor may utilize the value pre-stored in the memory to determine that the electronic device 200 is in a closed state. As described above, a processor connected to the drive device 430 may determine whether the electronic device 200 is in a unfolded state through a second Hall sensor 620 disposed at a hinge portion of the electronic device 200. For example, the first housing 210 may include a second Hall sensor 620 disposed adjacent to the hinge device 300, and the second housing 220 may include a second magnetic member 621 disposed adjacent to the hinge device 300. The second Hall sensor 620 and the second magnetic member 621 may be disposed in the first housing 210 and the second housing 220, respectively, so that the electronic device 200 is adjacent in the unfolded state (see FIG. 3b). A memory of the electronic device 200 may pre-store a value measuring a change in magnetic field as a function of distance between the second Hall sensor 620 and the second magnetic member 621. The processor may use the pre-stored value in the memory to determine that the electronic device 200 is in the unfolded state. **In** addition to the Hall sensors 610 and 620 described above, various configurations that may be practiced by a person of ordinary skill in the art may be used to determine whether the electronic device 200 is in the closed or unfolded state.

The opening operation of the electronic device 200 expressed in this document may have substantially the same meaning as the unfolding operation of the aforementioned electronic device 200, and the closing operation of the electronic device 200 may have substantially the same meaning as the folding operation of the elevated electronic device 200.

According to various embodiments, the opening operation of the electronic device 200, as shown in FIG. 8a, may be implemented by commands such as the following. When the electronic device 200 is in the folded state, the electronic device 200 may be in an open lock state so that the electronic device 200 is prevented from opening in the absence of external input (e.g., the first input signal 712). The open lock state of the electronic device 200 may be released 710 using conventional security devices such as pattern input, facial recognition, fingerprint recognition, password input, etc. Once the open lock is released 710, the electronic device 200 may enter an open standby state 711. **In** the open standby state 711, when a first input signal 712 is generated through the input device 600, the processor may control 713 the drive device 430 based on the first input signal 712. For example, based on the first input signal 712, the processor may control 713 and 714 the drive device 430 to rotate the drive shaft 431 of the drive device 430 in a first direction (e.g., the direction in which the electronic device opens). The first input signal 712 may come from an input device 600 electrically coupled to the processor and the drive device 430. In one embodiment, the input device 600 may be a physical button (e.g., the physical button 250 of FIG. 2a) that, when pressed by an external force, generates an electrical signal. The first input signal 712 generated through the input device 600 may be an electrical signal caused by a physical external force applied by a user. In some embodiments, the input device 600 may include an input sensor (not shown) that detects a touch. In this case, the first input signal 712 may be a signal generated by a touch detected by an input sensor disposed on the input device 600. In another embodiment, the external input device may mean the display module 230. In this case, the first input signal 712 may be a signal generated by a user manipulating a user interface (UI) displayed on the display module 230.

In one embodiment, in the case that an external collision occurs during the unfolding of the electronic device 200, the processor may determine 715 whether a collision has occurred and may control 719 a motor of the drive device 430 to stop operation of the drive device 430. The electronic device 200 may include a current sensor connected to the processor and the drive device 430. The current sensor may be coupled to the drive device 430 to detect the strength of the current generated by the drive device 430. The processor may measure the strength of the current detected by the current sensor to determine whether the electronic device 200 is colliding 715. For example, in the case that the electronic device 200 has experienced an external collision, the processor may measure the current strength above a threshold through the current sensor. When the processor measures a current above the threshold, the processor may stop the operation of the drive device 430 719. Accordingly, damage to the drive device 430 from external forces caused by a collision applied to the hinge device 200 may be prevented.

In one embodiment, the processor may determine whether the electronic device 200 has reached a fully unfolded state 716 through the aforementioned second Hall sensor 620 and the second magnetic member 621. In the memory of the electronic device 200, a measured value of the change in the magnetic field with regard to the distance between the second Hall sensor 620 and the second magnetic member 621 may be stored in advance. The processor may determine whether the electronic device 200 is in the open state 716 based on the values pre-stored in memory. The processor may control 719 the drive device 430 so that the rotation in the first direction of the drive shaft 431 stops based on the unfolded state of the electronic device 200. Accordingly, the electronic device 200 may remain unfolded as the drive device 430 stops.

In one embodiment, the processor may control the drive device 430 to stop rotation of the drive shaft 431 based on a third input signal 717 and 727 generated through the input device 600 during the unfolding of the electronic device 200. Here, the third input signals 717 and 727 may mean the first input signal 712 and/or the second input signal 722, which will be described later, generated again through the input device 600 in response to a user's operation. For example, in the case that the first input signal 712 is again generated by applying an input (e.g., press, touch) to the input device 600 once again during the operation of unfolding the electronic device 200, the processor may control the drive device 430 to stop rotation of the drive shaft 431 of the drive device 430 in a first direction (e.g., the direction in which the electronic device 200 opens) based on the first input signal 712 (e.g., the third input signals 717 and 727). In this state, the processor may control an angular displacement of the drive shaft 431. For example, the processor may control the angular displacement of the drive shaft 431 through the drive device 430 to adjust the angle that the first housing 210 and the second housing 220 form. In one embodiment, where the input device 600 is a physical button 250, the angle between the first housing 210 and the second housing 220 can be adjusted by a user by pressurizing the physical button 250. In one embodiment, the input device 600 may include an input sensor that detects a touch. When the input sensor is input 730 with a touch (e.g., drag, slide) in one direction, the processor may control 731 the drive device 430 to rotate the drive shaft 431 in the first direction (e.g., the direction in which the electronic device 200 is to be unfolded) based on the touch in one direction detected by the input sensor. For example, the processor may control the drive device 430 to rotate the drive shaft 431 in the first direction (e.g., the direction in which the electronic device 200 is to be unfolded) when the input sensor indicates a drag or slide in the first direction. Conversely, in the case that a touch (e.g., drag, slide) in a direction opposite to the first direction is input 730 to the input sensor, the processor may control the drive device 430 to rotate the drive shaft 431 in the second direction (e.g., the direction in which the electronic device 200 is to be closed) based on the touch detected by the input sensor. For example, the processor may control the drive device 430 to rotate the drive shaft 431 in the first direction (e.g., the direction in which the electronic device 200 is to be unfolded) when the input sensor indicates a drag or slide in the opposite direction of the first direction. Accordingly, the processor may control the drive device 430 to rotate in the direction in which the electronic device 200 is folded or unfolded based on the direction of the touch detected by the input sensor.

In one embodiment, the processor may control an angle between the first housing 210 and the second housing 220 based on the strength of the touch applied to the input sensor. For example, when the touch applied to the input sensor is strong, the processor may control the degree to which the electronic device 200 is folded or unfolded through the drive device 430 based on the strength of the touch applied to the input sensor. When the touch applied to the input sensor is weak, the processor may control the degree to which the electronic device 200 is folded or unfolded through the drive device 430 based on the strength of the touch applied to the input sensor. In addition, the processor may control the speed at which the electronic device 200 is folded or unfolded based on the strength of the touch applied to the input sensor. For example, the processor may control the speed at which the drive shaft 431 of the drive device 430 rotates in a first direction (e.g., in a direction in which the electronic device 200 is to be unfolded) or a second direction (e.g., in a direction in which the electronic device 200 is to be closed) based on the strength of the touch detected by the input sensor. In various embodiments disclosed in this document, the angle between the first housing 210 and the second housing 220 may be adjusted through the input device 600. The ability to finely adjust the angle between the first housing 210 and the second housing 220 may increase the usability and convenience of the electronic device 200.

According to various embodiments, the closing operation of the electronic device 200, as shown in FIG. 8b, may be implemented by commands such as the following. When the electronic device 200 is in the open state, the electronic device 200 may be in a close lock state to prevent the electronic device 200 from closing in the absence of external input (e.g., the second input signal 722). The close lock state of the electronic device 200 may be released 720 using conventional security devices such as pattern input, facial recognition, fingerprint recognition, or password input. Once the close lock is released 720, the electronic device 200 may enter a close standby state 721. When the input device 600 receives the second input signal 722 while in the close standby state 721, the processor may control the drive device 430 based on the second input signal 722. For example, based on the second input signal 722, the processor may control the drive device 430 to rotate the drive shaft 431 of the drive device 430 in a second direction (e.g., a direction in which the electronic device is closed). The second input signal 722 may come from an input device 600 electrically coupled to the processor and drive device 430. In one embodiment, the input device 600 may be a physical button (e.g., the physical button 250 of FIG. 2a) that, when pressed by an external force, generates an electrical signal. The second input signal 722 generated through the input device 600 may be an electrical signal caused by a physical external force applied by a user. In some embodiments, the input device 600 may include an input sensor (not shown) that detects a touch. In this case, the second input signal 722 may be a signal generated by a touch detected by an input sensor disposed on the input device 600. In another embodiment, the input device 600 may mean the display module 230. In this case, the second input signal 722 may be a signal generated by a user manipulating a user interface (UI) displayed on the display module 230.

In one embodiment, in the case that an external collision occurs while the electronic device 200 is being folded, the processor may determine 725 whether an external collision has occurred and may control 729 a motor of the drive device 430 to stop operation of the drive device 430. The electronic device 200 may include a current sensor connected to the processor and the drive device 430. The current sensor may be coupled to the drive device 430 to detect the strength of the current generated by the drive device 430. The processor may measure the strength of the current detected through the current sensor to determine 725 whether the electronic device 200 is colliding. For example, in the case that the electronic device 200 has experienced an external collision, the processor may measure the current strength above a threshold through the current sensor. When the processor measures a current above the threshold, the processor may control 729 the motor of the drive device 430 to stop the operation of the drive device 430. Accordingly, damage to the drive device 430 from external forces caused by a collision applied to the hinge device 200 may be prevented.

In one embodiment, the processor may determine whether the electronic device 200 has reached a fully folded state 726 through the aforementioned first Hall sensor 610 and the first magnet member 611 described above. In the memory of the electronic device 200, the measured value of the magnetic field change with regard to the distance between the first Hall sensor 610 and the first magnet member 611 may be stored in advance. The processor may use a value pre-stored in memory to determine whether the electronic device 200 is in a folded state 726. The processor may control 729 the drive device 430 so that the rotation in the second direction of the drive shaft 431 stops based on the folded state of the electronic device 200. Accordingly, the electronic device 200 may remain folded state as the drive device 430 stops.

In one embodiment, the processor may control the drive device 430 to stop rotation of the drive shaft 431 based on a third input signal 717 and 727 generated through the input device 600 during the process of folding the electronic device 200. Here, the third input signals 717 and 727 may mean the first input signal 712 and/or the second input signal 722 generated again through the external input device 600 in response to a user's operation. For example, when the second input signal 722 is again generated by applying an input (e.g., press, touch) to the input device 600 once again during the operation of closing the electronic device 200, the processor may control the drive device 430 to stop rotation of the drive shaft 431 in the second direction (e.g., the direction in which the electronic device 200 is closed) based on the second input signal 722 (e.g., the third input signals 717 and 727). In this state, the processor may control an angular displacement of the drive shaft 431. For example, the processor may control the angular displacement of the drive shaft 431 through the drive device 430 to adjust the angle that the first housing 210 and the second housing 220 form. In one embodiment, where the input device 600 is a physical button 250, the angle between the first housing 210 and the second housing 220 may be adjusted by a user by pressurizing the physical button 250. In one embodiment, when the input device 600 is a physical button 250, the angle between the first housing 210 and the second housing 220 may be adjusted by a user by pressurizing the physical button 250. In one embodiment, the input device 600 may include an input sensor that detects a touch. When a touch (e.g., drag, slide) in one direction is input to the input sensor, the processor may control the drive device 430 to rotate the drive shaft 431 in the first direction (e.g., the direction in which the electronic device 200 is to be unfolded) based on the touch in one direction detected by the input sensor. For example, the processor may control the drive device 430 to rotate the drive shaft 431 in the first direction (e.g., the direction in which the electronic device 200 is to be unfolded) when the input sensor indicates a drag or slide in the first direction. Conversely, in the case that a touch (e.g., drag, slide) in a direction opposite to the first direction is input to the input sensor 730, the processor may control the drive device 430 to rotate the drive shaft 431 in the second direction (e.g., the direction in which the electronic device 200 is to be closed) based on the touch detected by the input sensor. For example, the processor may control the drive device 430 to rotate the drive shaft 431 in the first direction (e.g., the direction in which the electronic device 200 is to be unfolded) when the input sensor indicates a drag or slide in the opposite direction of the first direction. Accordingly, the processor may control the drive device 430 to rotate in the direction in which the electronic device 200 is folded or unfolded based on the direction of the touch detected by the input sensor.

Although it has been described above as being recognized through a touch recognition input sensor, the method of adjusting the angle between the first housing 210 and the second housing 220 may be changed in various ways. For example, when the electronic device 200 is in an intermediate state, the processor may display a UI for adjusting the angle between the first housing 210 and the second housing 220 on the display module 230. The user may adjust the angle between the first housing 210 and the second housing 220 by touching the UI displayed on the display module 230. In addition, the angle between the first housing 210 and the second housing 220 may be adjusted through various ways.

In the various embodiments disclosed in this document, the angle between the first housing 210 and the second housing 220 may be adjusted through input device 600. By allowing the angle between the first housing 210 and the second housing 220 to be finely adjusted, the usability and convenience of the electronic device 200 may be increased.

The operation of the processor for operating the drive device 430 described above is only an example, and the processor may operate the drive device 430 through various methods that can be performed by a person of ordinary skill in the art. In one embodiment, the processor may use a gyro sensor and a position sensor disposed on the electronic device 200 to recognize a specific motion (e.g., a shaking) generated in the electronic device 200 and control the drive 430 so that the electronic device 200 is closed or or unfold. In another embodiment, the processor may control drive device 430 so that electronic device 200 is folded or unfolded by recognizing the user's voice such as "Unfold electronic device 200" or "Close electronic device 200".

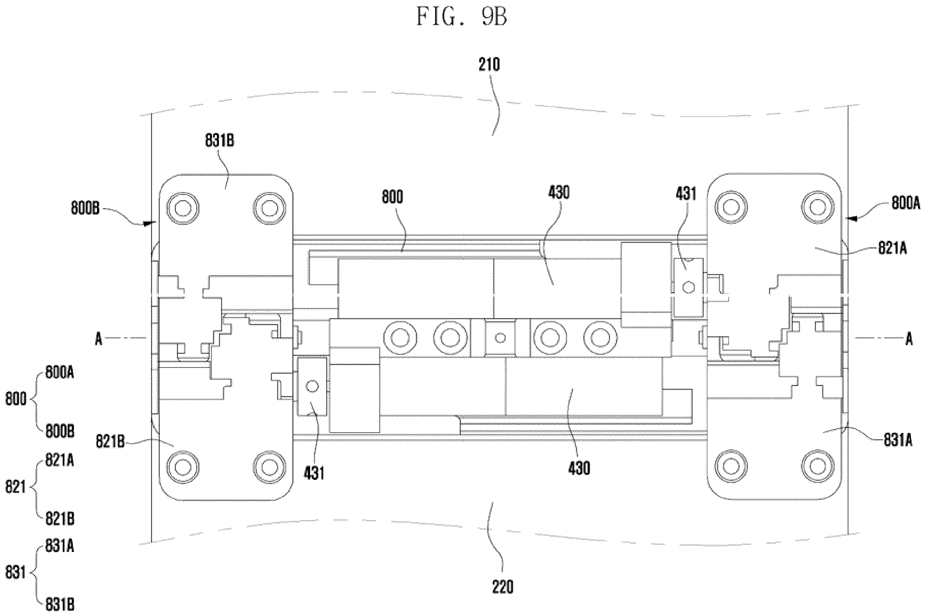

FIG. 9a is an exploded perspective view of a hinge device according to another embodiment disclosed in the present document. FIG. 9b is a front view of a hinge device according to another embodiment disclosed in the present document.

In the following description, components that are the same or similar to those previously described in FIGS. 3a to 8b will be described using the same member numbers, and descriptions that are redundant with the previous description may be briefly described or omitted.

According to various embodiments, the hinge device 800 shown in FIGS. 9a and 9b may include a bracket 810, a first rotating member 820, a second rotating member 830, a first limiting member 410, a second limiting member 420 and a drive device 430. The hinge device 800 shown in FIGS. 9a and 9b may be in the form of omitting the first arm 340 and the second arm 350 described in FIGS. 4a to 4d.

According to various embodiments, the bracket 810, as shown in FIG. 9a, may include a first rail 811 and a second rail 812. The bracket 810 shown in FIG. 9a may include substantially the same configuration as the bracket 810 shown in FIGS. 4a to 4c. In one embodiment, the first rail 811 may be a portion on which a first rotating portion 822 of the first rotating member 820 and a first gear 823 formed on the first rotating portion 822 are disposed. The first rotating portion 822 may be rotatably coupled to the first rail 811 with regard to the bracket 810. The first rotating member 820 may rotate with the first rotating portion 822 with regard to the bracket 810 as the first rotating portion 822 is fastened to the first rail 811. The first gear 823 may be a gear that meshes with the second gear 840 of the drive device 430. In one embodiment, the second rail 812 may be a portion on which the second rotating portion 832 of the second rotating member 830 is disposed. The second rotating portion 832 may be rotatably coupled to the second rail 812 with regard to the bracket 810. The second rotating member 830 may rotate with the second rotating portion 832 with regard to the bracket 810 as the second rotating portion 832 is fastened to the second rail 812.

In one embodiment, the bracket 810 may include a shaft 315. The shaft 315 may be integrated with the bracket 810 and may be inserted into the insertion hole 816 formed on the bracket 810 and joined to the bracket 810. The first body portion 411 of the first limiting member 410 and the second body portion 421 of the second limiting member 420 may be inserted into the shaft 315. The first body portion 411 and the second body portion 421 may rotate with regard to the bracket 810 in response to the rotation of the first rotating member 820 and the second rotating member 830 as the first contact portion 413 and second contact 423 are in contact with the first rotating portion 822 and the second rotating portion 832, respectively.

According to various embodiments, the first rotating member 820 of the hinge device 800 may include a first rotating portion 822 and a first gear 823 formed on the first rotating portion 822. The first gear 823 may be formed integrally with the first rotating portion 822, and may be coupled to the first rotating portion 822 through various coupling methods (e.g., bolt coupling, rivet coupling, adhesive coupling, volumetric coupling). The first gear 823 may mesh with the second gear 840 connected to the drive shaft 431 of the drive device 430. The drive device 430 may rotate the first rotating member 820 by transmitting the driving shaft 431 to the driving shaft 431 - the second gear 840 - the first gear 823.

According to various embodiments, the first rotating member 820 of the hinge device 800 may include the first plate 821. The second rotating member 830 of the hinge device 800 may include the second plate 831. The first plate 821 and the second plate 831 may be combined with the first housing 210 or the second housing 220 to support the display module 230.

According to various embodiments, as shown in FIG. 9a, the bracket 810 may be disposed with a first limiting member 410 that limits rotation of the first rotating member 820 and a second limiting member 420 that limits rotation of the second rotating member 830. The configuration of the first limiting member 410 and the second limiting member 420 may be substantially the same as the configuration of the first limiting member 410 and the second limiting member 420 described in FIGS. 4a to 4c. The first limiting member 410 may include a first body portion 411, a first contact portion 413, and a first pressurizing member 414 formed of an elastic material. The first body portion 411 may rotate with regard to 810 about the shaft 315 as the shaft 315 of the bracket 810 is inserted into the first center hole 411-1. The first contact portion 413 may be formed at one end of the first body portion 411 and may contact the first rotating portion 822 of the first rotating member 820. The first contact portion 413 may be integrally formed with the first body portion 411, or may otherwise be coupled to the first side of the first body portion 411 in a variety of other ways (e.g., bolt coupling, rivet coupling, adhesive coupling, volumetric coupling). A first pressurizing member 414 may be disposed in a first seating area formed in the bracket 810 to pressurize an end of the first body portion 411. The second limiting member 420 may include a second body portion 421, a second contact portion 423, and a second pressurizing member 424 formed of an elastic material. The second body portion 421 may rotate with regard to 810 about the shaft 315 as the shaft 315 of the bracket 810 is inserted into the second center hole 421-1. The second contact portion 423 may be formed at one end of the second body portion 421 and may contact the second rotating portion 832 of the second rotating member 830. The second contact portion 423 may be integrally formed with the second body portion 421, or may otherwise be coupled to a first side of the second body portion 421 in a variety of ways (e.g., bolt coupling, rivet coupling, adhesive coupling, volumetric coupling). A second pressurizing member 424 may be disposed in a second seating area formed in the bracket 810 to pressurize an end of the second body portion 421. In the above, the configuration of the first limiting member 410 and the second limiting member 420 has been briefly described. Reference is now made to the descriptions of FIGS. 4a to 6d, which describe how the first limiting member 410 and the second limiting member 420 are coupled to the bracket 810, and how the first rotating portion 822 and the second rotating portion 832 are pressurized to implement a stopping operation or a free-stop.

According to various embodiments, the hinge device 800 may include a first hinge device 800A and a second hinge device 800B. The first hinge device 800A and the second hinge device 800B may be identical to the configuration of the hinge device 800 described earlier. However, the first hinge device 800A and the second hinge device 800B may differ in the position where they are combined to the first housing 210 and the second housing 220. With reference to FIG. 9b in one embodiment, the first plate 821A of the first rotating member 820 of the first hinge device 800A may be combined with the first housing 210, and the second plate 831A of the second rotating member 830 may be combined with the second housing 220. The first plate 821B of the first rotating member 820 of the second hinge device 800B may be coupled with the second housing 220, and the second plate 831B of the second rotating member 830 may be combined with the first housing 210.

In one embodiment, the first rotating members 820 of the first hinge device 800A and the second hinge device 800B may rotate with regard to 810 as the drive device 430 operates. The first rotating member 820 may rotate with regard to the bracket 810 as the driving force from the drive device 430 is transmitted to the drive shaft 431 - the second gear 840 of the drive device 430 - the first gear 823 of the first rotating member 820. In one embodiment, the first rotating member 820 of the first hinge device 800A may rotate about an axis parallel to the width direction of the electronic device 200 (e.g., the A-A axis in FIG. 9a) as the drive device 430 of the first hinge device 800A operates. The first housing 210 may rotate about the A-A axis as it is coupled to the first plate 821A of the first hinge device 800A. The second rotating member 830 of the second hinge device 800B may rotate about the A-A axis with the first housing 210 as it is coupled to the first housing 210 through the second plate 831B. In one embodiment, the first rotating member 820 of the second hinge device 800B may rotate about the A-A axis as the drive device 430 of the second hinge device 800B operates. The second housing 220 may rotate about the A-A axis as it is coupled to the first plate 821B of the second hinge device 800B. The second rotating member 830 of the first hinge device 800A may rotate about the A-A axis with the second housing 220 as it is coupled to the second housing 220 through the second plate 831A.

According to various embodiments, a processor (e.g., the processor 120 of FIG. 1) may be connected to the first hinge device 800A and the second hinge device 800B. The processor may interwork the drive device 430 included in the first hinge device 800A and the second hinge device 800B so that the first hinge device 800A and the second hinge device 800B can rotate with the same angular displacement. The processor may be coupled to a configuration that measures and provides feedback on the moved angles of the first hinge device 800A and the second hinge device 800B. For example, the processor may be coupled to an absolute encoder that measures the angle of rotation of the drive device 430 through an electrical signal that is generated at each division from 0 to 180 degrees at a constant ratio. Through the absolute encoder, the processor may always know the rotation angle of the first hinge device 800A and the rotation angle of the second hinge device 800B. Accordingly, the processor may interwork the drive devices 430 included in the first hinge device 800A and the second hinge device 800B so that the first hinge device 800A and the second hinge device 800B can rotate with the same angular displacement. In addition, the drive devices 430 of the first hinge device 800A and the second hinge device 800B may be interworked in various configurations as practiced by a person of ordinary skill in the art.

According to various embodiments disclosed in this document, the electronic device 200 may be disposed with a plurality of drive devices 430. The electronic device 200 may transition from a closed state to an unfolded state or from an unfolded state to a closed state by the operation of the drive device 430 of the first hinge device 800A and the drive device 430 of the second hinge device 800B. The drive device 430 of the first hinge device 800A and the second hinge device 800B may be coupled with a configuration that measures and feeds back an angle of movement of the second hinge device 800B of the first hinge device 800A, such as an absolute encoder. Accordingly, the drive device 430 of the first hinge device 800A and the second hinge device 800B may be operated to enable the first hinge device 800A and the second hinge device 800B to rotate with the same angular displacement by interworking the drive devices 430 of the first hinge device 800A and the second hinge device 800B.

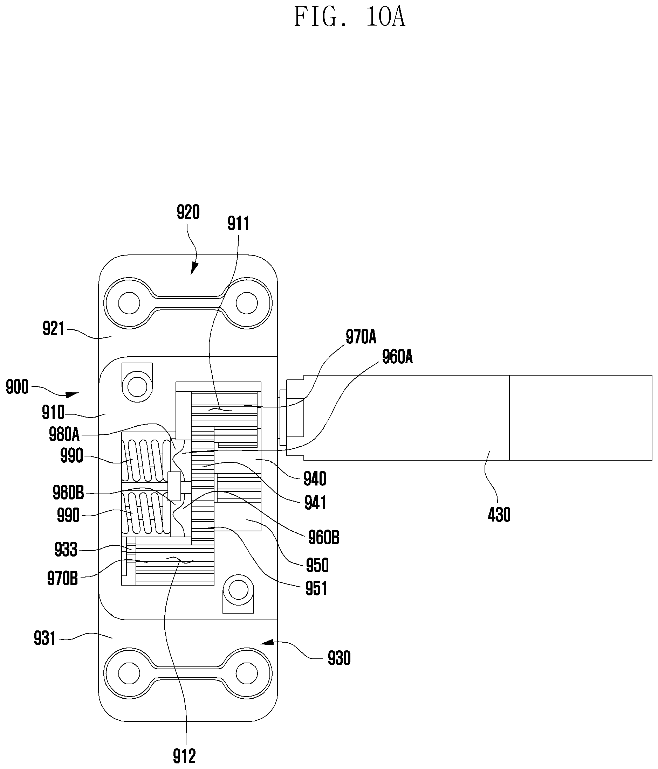

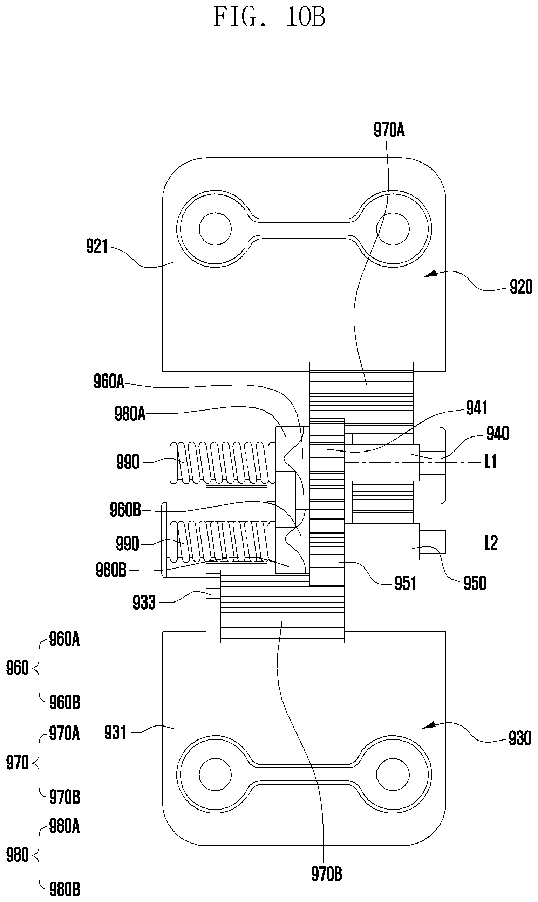

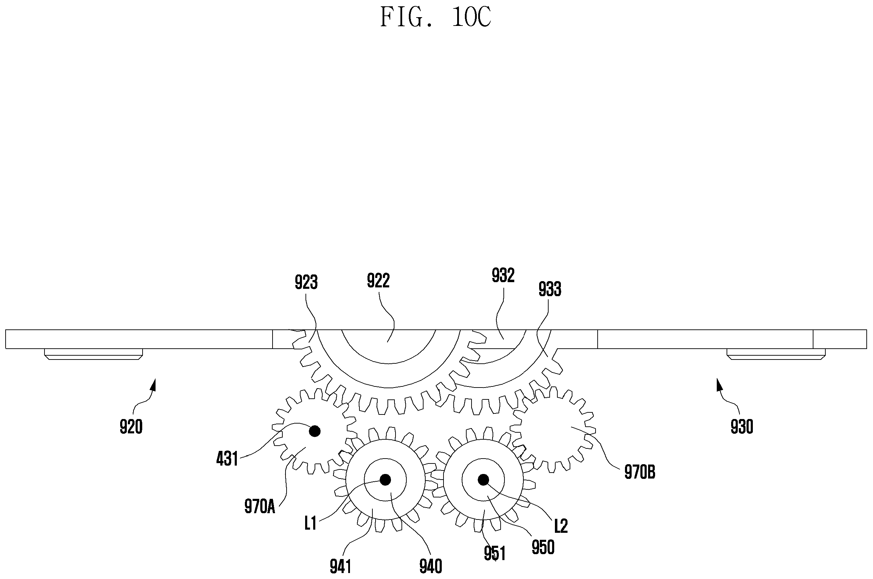

FIG. 10a is a front view of a hinge device according to another embodiment disclosed in the present document. FIG. 10b is a diagram illustrating the gear interworking structure of a hinge device according to another embodiment disclosed in the present document. FIG. 10c is a side view of FIG. 10a.

In the following description, components that are the same or similar to those previously described in FIGS. 3a to 8b, 9a, and 9b will be described using the same member numbers, and descriptions that are redundant with the previous description will be briefly described or omitted.

According to various embodiments, the hinge device 900 shown in FIG. 10a to 10c may include a bracket 910, a first rotating member 920, a second rotating member 930, a first shaft 940, a second shaft 950 and a drive device 430. The hinge device 900 shown in FIGS. 10a to 10b may be in the form of omitting the first arm 340 and the second arm 350 described in FIGS. 4a to 4d.

According to various embodiments, the bracket 910, as shown in FIG. 10a, may include a first rail 911 and a second rail 912. The bracket 910 shown in FIG. 10a may include substantially the same configuration as the bracket 310 shown in FIGS. 4a to 4c. In one embodiment, the first rail 911 may be a portion on which a first rotating portion 922 of the first rotating member 920 and a first gear 923 formed on the first rotating portion 922 are disposed. The first rotating portion 922 may be rotatably coupled to the first rail 911 with regard to the bracket 910. The first rotating member 920 may rotate with the first rotating member 922 with regard to the bracket 910 as the first rotating member 922 is fastened to the first rail 911. The first gear 923 may rotate with the first idle gear 970A by coupling the first idle gear 970A disposed on the bracket 910. In one embodiment, the second rail 912 may be a portion of the second rotating portion 932 of the second rotating member 930 and a second gear 933 formed on the second rotating portion 932. The second rotating portion 932 may be rotatably coupled to the second rail 912 with regard to the bracket 910. The second rotating member 930 may rotate with the second rotating portion 932 with regard to the bracket 910 as the second rotating portion 932 is fastened to the second rail 912. The second gear 933 may rotate with the second idle gear 970B by interlocking the second idle gear 970B disposed on the bracket 910.

According to various embodiments, the first rotating member 920 may include a first gear 923. The first gear 923 may be formed on the first rotating portion 922. In one embodiment, the first gear 923 may be formed integrally with the first rotating portion 922, and may be coupled to the first rotating portion 922 through various coupling methods (e.g., bolt coupling, rivet coupling, adhesive coupling, volumetric coupling). The second rotating member 930 may include a second gear 933. The second gear 933 may be formed on the second rotating portion 932. In one embodiment, the second gear 933 may be formed integrally with the second rotating portion 932, and may be coupled to the second rotating portion 932 through various coupling methods.

In one embodiment, the first rotating member 920 may include the first plate 921. The second rotating member 930 may include the second plate 931. The first plate 921 and the second plate 931 may be coupled to the first housing 210 or the second housing 220 to support the display module 230.

According to various embodiments, as shown in FIGS. 10a to 10c, the hinge device 900 may include a first cam structure 960A formed at one end, a first shaft 940 comprising a third gear 941 connected to the first cam structure 960A, a second cam structure 960B formed at one end, and a second shaft 950 comprising a fourth gear 951 connected to the second cam structure 960B. The hinge device 900 may include a pressurizing body 980 including a first cam portion 980A having a shape corresponding to the first cam structure 960A of the first shaft and a second cam portion 980B having a shape corresponding to the second cam structure 960B of the second shaft 950. In one embodiment, the first shaft 940, the second shaft 950, and the pressurizing body 980 may be disposed on the bracket 910. In one embodiment, the first shaft 940 may be disposed on the bracket 910 so that the first cam structure 960A meshes with the first cam portion 980A of the pressurizing body 980. The second shaft 950 may be disposed on the bracket 910 so that the second cam structure 960B meshes with the second cam portion 980B of the pressurizing body 980.

According to various embodiments, the hinge device 900 may include a plurality of pressurizing members 990 that pressurize the pressurizing body 980. In one embodiment, with reference to FIG. 10a, the pressurizing members 990 may be formed of a material with elasticity such as a spring. With reference to FIG. 10a, the pressurizing member 990 may be disposed in a compressed state on the bracket 910 to pressurize a portion of the pressurizing body 980 so that the cam portions 980A and 980B of the pressurizing body 980 and the cam structure 960 of the shafts 940 and 950 are in contact. As the pressurizing member 990 pressurizes the pressurizing body 980, the cam portions 980A and 980B of the pressurizing body 980 may pressurize the cam structures 960 of the shafts 940 and 950. When the electronic device 200 is in the folded or unfolded state, the cam portions 980A and 980B of the pressurizing body 980 and the cam structure 960 of the shafts 940 and 950 may mesh, and the electronic device 200 may implement a stopping operation in the folded or unfolded state as the cam portions 980A and 980B of the pressurizing body 980 pressurize the cam structure 960 through the pressurizing member 990.

In one embodiment, the first shaft 940 and the second shaft 950 may rotate about the axis of rotation L1 and L2. The pressurizing body 980 may mesh the cam portions 980A and 980B with the cam structure 960 of the shafts 940 and 950, and may retract with regard to the shafts 940 and 950 as the shaft rotates. In this process, the pressurizing member 990 may be compressed in the direction of the retraction of the pressurizing body 980, and the cam structure 960 and the cam portions 980A and 980B of the pressurizing body 980 may be restored to its original shape as they are interlocked again. The electronic device 200 may be in a folded or unfolded state and maintain a stopping operation in the folded or unfolded state as the cam structure 960 of the shaft 940 and 950 and the cam portion 980 of the pressurizing body 980 are re-interlocked.

In one embodiment, a friction may occur between the cam portion 980A and 980B of the pressurizing body 980 and the cam structure 960 of the shaft 940 and 950 in the process of transitioning from the unfolded state to the folded state or from the folded state to the unfolded state. The frictional force between the cam portions 980A and 980B and the cam structure 960 may be involved in the free-stop operation of the electronic device 200. In addition, the stopping operation or free-stop operation of the electronic device 200 through the hinge device 900 may be implemented by the torque TM provided by the drive device 430 described in FIG. 6a to 6d.

According to various embodiments, the first shaft 940 and the second shaft 950 may be disposed in a bracket 910 so that the third gear 941 formed on the first shaft 940 and the fourth gear 951 formed on the second shaft 950 are interlocked.

In one embodiment, the hinge device 900 may include a plurality of idle gears 970. The idle gear 970 may interwork the rotation of the first rotating member 920 and the second rotating member 930. The idle gear 970 may be interworked to rotate the first rotating member 920 and the second rotating member 930 in opposite directions. For example, first rotating member 920 and second rotating member 930 may rotate in opposite directions in the course of electronic device 200 transitioning from unfolded to folded state or from folded to unfolded state. The idle gear 970 may be an even number so that the first rotating member 920 and the second rotating member 930 are interworked and rotate in opposite directions.

In one embodiment, the idle gear 970 may include a first idle gear 970A and a second idle gear 970B. The first idle gear 970A and the second idle gear 970B may be disposed on the bracket 910 to mesh. With reference to FIG. 10c, the first gear 923 may be spaced with regard to the third gear 941 so that it does not mesh with the third gear 941. The second gear 933 may be spaced with regard to the fourth gear 951 and may not mesh with the fourth gear 951. The first idle gear 970A may be disposed to mesh with the first gear 923 of the first rotating member 920 and the third gear 941 of the first shaft 940 to interwork the first gear 923 and the third gear 941. The second idle gear 970B may be disposed to mesh with the second gear 933 of the second rotating member 930 and the fourth gear 951 of the second shaft 950 to interwork the second gear 933 with the fourth gear 951. In summary, as the first gear 923 - first idle gear 970A - third gear 941 - fourth gear 951 - second idle gear 970B - second gear 933 interwork with each other, the first rotating member 920 and the second rotating member 930 may be interworked to rotate in opposite directions.

In one embodiment, the first shaft 940 and the second shaft 950 may be interworked to rotate in opposite directions from each other through the idle gear 970. The first shaft 940 and the second shaft 950 may be interworked with the first rotating member 920 and the second rotating member 930 to rotate with the first rotating member 920 and the second rotating member 930 with regard to a bracket 910. For example, the first shaft 940 may rotate with regard to a bracket 910 about an axis L1 in the longitudinal direction of the first shaft 940. The second shaft 950 may rotate with regard to a bracket 910 about an axis L2 in the longitudinal direction of the second shaft 950. As the first shaft 940 is interworked with the first rotating member 920 through the first idle gear 970A, the direction of rotation of the first shaft 940 may be the same as the direction of rotation of the first rotating member 920. As the second shaft 950 is interworked with the second rotating member 930 through the second idle gear 970B, the direction of rotation of the second shaft 950 may be the same as the direction of rotation of the second rotating member 930.

In one embodiment, the drive device 430 of the hinge device 900 may be coupled to at least one of the first gear 923, the second gear 933, the third gear 941, the fourth gear 951, the first idle gear 970A, and the second idle gear 970B. The following description will assume that the drive shaft 431 of the drive device 430 is connected to the first idle gear 970A. The drive shaft 431 of the drive device 430 may be connected with the first idle gear 970A. The first idle gear 970A may rotate about the drive shaft 431 as the drive device 430 operates. The driving force of the drive device 430 may be transmitted from the drive shaft 431 to the first idle gear 970A. As the first idle gear 970A rotates, the first gear 923, the third gear 941, the fourth gear 951, the second idle gear 970B, and the second gear 933 interworked with the first idle gear 970A may rotate in interworking with each other.

The hinge device 900 according to various embodiments disclosed in this document may include a plurality of gears interworked with each other. In one embodiment, the idle gears 970 may include a first idle gear 970A and a second idle gear 970B. The first idle gear 970A may be disposed to mesh a first gear 923 of the first rotating member 920 and a third gear 941 of the first shaft 940. The second idle gear 970B may be disposed to mesh the second gear 933 of the second rotating member 930 and the fourth gear 951 of the second shaft 950. The first rotating member 920 and the second rotating member 930 may be interworked to rotate in opposite directions through the first idle gear 970A and the second idle gear 970B. The first idle gear 970A may be connected to the drive shaft 431 of the drive device 430 to rotate in response to operation of the drive device 430. The driving force of the drive device 430 may be transmitted to the first gear 923, the third gear 941, the fourth gear 951, the second idle gear 970B, and the second gear 933, which are interworked with the first idle gear 970A. Accordingly, the first rotating member 920 and the second rotating member 930 of the hinge device 900 may be interworked to rotate in opposite directions through the plurality of gears.

In addition, the embodiments of the present document disclosed in the present specification and drawings are merely presented as specific examples to easily explain the technical contents according to the embodiments disclosed in the present document and to facilitate the understanding of the embodiments disclosed in the present document, but are not intended to limit the scope of the embodiments disclosed in the present document. Therefore, the scope of the various embodiments disclosed in the present document should be interpreted to include all changes or modifications derived based on the technical ideas of the various embodiments disclosed in the present document, in addition to the embodiments disclosed in the present document, within the scope defined by the appended set of claims.

## Claims

1. An electronic device (101, 200) comprising:
a first housing (210);
a second housing (220); and
a hinge device (300) foldably connecting the first housing (210) and the second housing (220), wherein
the hinge device (300) comprises:
a bracket (310) comprising a first rail (311) and a second rail (312) spaced apart from the first rail (311);
a first rotating member (320) comprising a first rotating portion (322) fastened to the first rail (311) of the bracket (310) so as to rotate with regard to the bracket (310);
a second rotating member (330) comprising a second rotating portion (332) fastened to the second rail (312) of the bracket (310) so as to rotate with regard to the bracket (310);
a first arm (340) which comprises a first gear (341), which is connected to the first rotating member (320) to be able to rotate with regard to the bracket (310), and which is connected to the first housing (210);
a second arm (350) which comprises a second gear (351), which is connected to the second rotating member (330) to be able to rotate with regard to the bracket (310), and which is connected to the second housing (220);
an interworking gear (380) meshing with the first gear (341) and the second gear (351) and rotating accordingly;
a first limiting member (410) disposed on the bracket (310), the first limiting member (410) comprising a first body portion (411), a first contact portion (413) and a first pressurizing member (414) made of an elastic material so as to pressurize the first contact portion (413) against the first rotating portion (322);
a second limiting member (420) disposed on the bracket (310), the second limiting member (420) comprising a second body portion (421), a second contact portion (423) and a second pressurizing member (424) made of an elastic material so as to pressurize the second contact portion (423) against the second rotating portion (332); and
a shaft (315) penetrating the bracket (310) and being configured to connect the first body portion (411) and the second body portion (421),
wherein the first body portion (411) and the second body portion (421) are configured to rotate with regard to the bracket (310).

2. The electronic device (101, 200) of claim 1, further comprising a drive device (430) configured to rotate at least one of the first gear (341), the second gear (351) and the interworking gear (380).

3. The electronic device (101, 200) of claim 1, wherein
the first contact portion (413) is disposed at one end of the first body portion (411), and the end of the first body portion (411) is pressurized through the first pressurizing member (414), and the second contact portion (423) is disposed at one end of the second body portion (421), and the end of the second body portion (421) is pressurized through the second pressurizing member (424).

4. The electronic device (101, 200) of claim 1, wherein
the rotation of the first rotating member (320) with regard to the bracket (310) is limited through contact with the first contact portion (413), and
the second rotating member (330) is configured to rotate with regard to the bracket (310) through contact with the second contact portion (423).

5. The electronic device (101, 200) of claim 1, wherein
the bracket (310) comprises a first seating portion (313) on which the first pressurizing member (414) is disposed and a second seating portion (314) on which the second pressurizing member (424) is disposed.

6. The electronic device (101, 200) of claim 3, wherein
the first contact portion (413) and the second contact portion (423) respectively comprise a bearing member (540) and are configured to rotate with regard to the first body portion (411) and the second body portion (421) respectively through the bearing member (540).

7. The electronic device (101, 200) of claim 1, wherein
the first rotating portion (322) and the second rotating portion (332) include a circular portion (510) having a circular cross-section, a stop portion (520) formed concave to the circular portion (510) and an end portion (530) that is one end of the circular portion (510), respectively, and the first contact portion (413) and the second contact portion (423) are contacted with at least one of the circular portion (510), the stop portion (520) and the end portion (530) according to the rotation of the first rotating member (320) and the second rotating member (330).

8. The electronic device (101, 200) of claim 7, wherein
the end portion (530) formed respectively in the first rotating portion (322) and the second rotating portion (332) is formed by at least a portion protruding from the circular portion (510).

9. The electronic device (101, 200) of claim 2, comprising a friction plate (432, 433) which is connected to a drive shaft (431) of the drive device (430) and is configured to rotate with regard to the bracket (310), wherein
the friction plate (432, 433) is configured to pressurize at least one of the first gear (341), the second gear (351) and the interworking gear (380).

10. The electronic device (101, 200) of claim 1, wherein
the first arm (340) is configured to rotate with regard to the bracket (310) with a rotation shaft different from the first rotating member (320), and is connected to the first rotating member (320) through a first pin (360) inserted into a first compensation rail (323) formed in the longitudinal direction of the first rotating member (320), and
the second arm (350) is configured to rotate with regard to the bracket (310) with a rotation shaft different from the second rotating member (330), and is connected to the second rotating member (330) through a second pin (370) inserted into a second compensation rail (333) formed in the longitudinal direction of the second rotating member (330).

11. The electronic device (101, 200) of claim 2, further comprising:
an input device (250, 600); and
a processor (120) connected to the input device (250, 600) and the drive device (430), wherein
the processor (120) is configured to:
control the drive device (430) to rotate a drive shaft (431) of the drive device (430) in a first direction based on a first input signal generated in the input device (200);
control the drive device (430) to rotate the drive shaft (431) of the drive device (430) in a second direction opposite to the first direction based on a second input signal generated in the input device (250, 600);
control the drive device (430) to stop rotation of the drive shaft (431) based on the third input signal generated in the input device (250, 600);
control the drive device (430) to stop rotation of the drive shaft (431) based on the current value greater than a threshold value detected through a current sensor connected to the processor (120) and the drive device (430); and
control the drive device (430) to stop rotation of the drive shaft (431) based on a state of the electronic device (101, 200) being in an unfolded or closed state.

12. The electronic device (101, 200) of claim 2, further comprising:
an input sensor; and
a processor (120) connected to the input sensor, wherein
the processor (120) is configured to control the drive device (430) so that a drive shaft (431) of the drive device (430) is configured to rotate in the first direction based on the touch in one direction detected in the input sensor, and is configured to control the drive device (430) so that the drive shaft (431) of the drive device (430) rotates in the second direction opposite to the first direction based on the touch in the direction opposite to the one direction detected in the input sensor.

## Patentansprüche

1. Elektronisches Gerät (101, 200), umfassend:
ein erstes Gehäuse (210);
ein zweites Gehäuse (220); und
eine Scharniervorrichtung (300), die das erste Gehäuse (210) und das zweite Gehäuse (220) faltbar verbindet, wobei
die Scharniervorrichtung (300) Folgendes umfasst:
eine Halterung (310) mit einer ersten Schiene (311) und einer zweiten Schiene (312), die von der ersten Schiene (311) beabstandet ist;
ein erstes Drehelement (320) mit einem ersten Drehabschnitt (322), der an der ersten Schiene (311) der Halterung (310) befestigt ist, um sich in Bezug auf die Halterung (310) zu drehen;
ein zweites Drehelement (330) mit einem zweiten Drehabschnitt (332), der an der zweiten Schiene (312) der Halterung (310) befestigt ist, um sich in Bezug auf die Halterung (310) zu drehen;
einen ersten Arm (340), der ein erstes Zahnrad (341) umfasst, das mit dem ersten Drehelement (320) verbunden ist, um sich in Bezug auf die Halterung (310) drehen zu können, und das mit dem ersten Gehäuse (210) verbunden ist;
einen zweiten Arm (350), der ein zweites Zahnrad (351) umfasst, das mit dem zweiten Drehelement (330) verbunden ist, um sich in Bezug auf die Halterung (310) drehen zu können, und das mit dem zweiten Gehäuse (220) verbunden ist;
ein Zusammenwirkungszahnrad (380), das mit dem ersten Zahnrad (341) und dem zweiten Zahnrad (351) in Eingriff steht und sich entsprechend dreht;
ein erstes Begrenzungselement (410), das an der Halterung (310) angeordnet ist, wobei das erste Begrenzungselement (410) einen ersten Körperabschnitt (411), einen ersten Kontaktabschnitt (413) und ein erstes Druckelement (414) aus einem elastischen Material umfasst, um den ersten Kontaktabschnitt (413) gegen den ersten Drehabschnitt (322) zu drücken;
ein zweites Begrenzungselement (420), das an der Halterung (310) angeordnet ist, wobei das zweite Begrenzungselement (420) einen zweiten Körperabschnitt (421), einen zweiten Kontaktabschnitt (423) und ein zweites Druckelement (424) aus einem elastischen Material umfasst, um den zweiten Kontaktabschnitt (423) gegen den zweiten Drehabschnitt (332) zu drücken; und
eine Welle (315), die die Halterung (310) durchdringt und so konfiguriert ist, dass sie den ersten Körperabschnitt (411) und den zweiten Körperabschnitt (421) verbindet,
wobei der erste Körperabschnitt (411) und der zweite Körperabschnitt (421) so konfiguriert sind, dass sie sich in Bezug auf die Halterung (310) drehen.

2. Elektronisches Gerät (101, 200) nach Anspruch 1, umfassend ferner eine Antriebsvorrichtung (430), die dazu konfiguriert ist, mindestens eines von dem ersten Zahnrad (341), dem zweiten Zahnrad (351) und dem Zusammenwirkungszahnrad (380) zu drehen.

3. Elektronisches Gerät (101, 200) nach Anspruch 1, wobei
der erste Kontaktabschnitt (413) an einem Ende des ersten Körperabschnitts (411) angeordnet ist und das Ende des ersten Körperabschnitts (411) durch das erste Druckelement (414) unter Druck gesetzt wird, während der zweite Kontaktabschnitt (423) an einem Ende des zweiten Körperabschnitts (421) angeordnet ist und das Ende des zweiten Körperabschnitts (421) durch das zweite Druckelement (424) unter Druck gesetzt wird.

4. Elektronisches Gerät (101, 200) nach Anspruch 1, wobei
die Drehung des ersten Drehelements (320) in Bezug auf die Halterung (310) durch Kontakt mit dem ersten Kontaktabschnitt (413) begrenzt ist, und
das zweite Drehelement (330) dazu konfiguriert ist, sich in Bezug auf die Halterung (310) durch Kontakt mit dem zweiten Kontaktabschnitt (423) zu drehen.

5. Elektronisches Gerät (101, 200) nach Anspruch 1, wobei
die Halterung (310) einen ersten Sitzabschnitt (313), auf dem das erste Druckelement (414) angeordnet ist, und einen zweiten Sitzabschnitt (314), auf dem das zweite Druckelement (424) angeordnet ist, umfasst.

6. Elektronisches Gerät (101, 200) nach Anspruch 3, wobei
der erste Kontaktabschnitt (413) und der zweite Kontaktabschnitt (423) jeweils ein Lagerelement (540) umfassen und so konfiguriert sind, dass sie sich über das Lagerelement (540) jeweils in Bezug auf den ersten Körperabschnitt (411) bzw. den zweiten Körperabschnitt (421) drehen.

7. Elektronisches Gerät (101, 200) nach Anspruch 1, wobei
der erste Drehabschnitt (322) und der zweite Drehabschnitt (332) jeweils einen kreisförmigen Abschnitt (510) mit einem kreisförmigen Querschnitt, einen zum kreisförmigen Abschnitt (510) konkav ausgebildeten Anschlagabschnitt (520) und einen Endabschnitt (530), der ein Ende des kreisförmigen Abschnitts (510) ist, umfassen, während der erste Kontaktabschnitt (413) und der zweite Kontaktabschnitt (423) entsprechend der Drehung des ersten Drehelements (320) und des zweiten Drehelements (330) mit mindestens einem von dem kreisförmigen Abschnitt (510), dem Anschlagabschnitt (520) und dem Endabschnitt (530) in Kontakt stehen.

8. Elektronisches Gerät (101, 200) nach Anspruch 7, wobei
der Endabschnitt (530), der jeweils in dem ersten Drehelement (322) bzw. dem zweiten Drehelement (332) ausgebildet ist, durch mindestens einen Abschnitt gebildet ist, der von dem kreisförmigen Abschnitt (510) vorsteht.

9. Elektronisches Gerät (101, 200) nach Anspruch 2, umfassend eine Reibungsplatte (432, 433), die mit einer Antriebswelle (431) der Antriebsvorrichtung (430) verbunden und dazu konfiguriert ist, sich in Bezug auf die Halterung (310) zu drehen, wobei
die Reibungsplatte (432, 433) dazu konfiguriert ist, mindestens eines von dem ersten Zahnrad (341), dem zweiten Zahnrad (351) und dem Zusammenwirkungszahnrad (380) unter Druck zu setzen.

10. Elektronisches Gerät (101, 200) nach Anspruch 1, wobei
der erste Arm (340) so konfiguriert ist, dass er sich in Bezug auf die Halterung (310) mit einer vom ersten Drehelement (320) verschiedenen Drehachse dreht, und über einen ersten Stift (360) mit dem ersten Drehelement (320) in Verbindung steht, der in eine erste Ausgleichsschiene (323) eingeführt ist, die in Längsrichtung des ersten Drehelements (320) ausgebildet ist, und
der zweite Arm (350) so konfiguriert ist, dass er sich in Bezug auf die Halterung (310) mit einer vom zweiten Drehelement (330) verschiedenen Drehachse dreht, und über einen zweiten Stift (370) mit dem zweiten Drehelement (330) in Verbindung steht, der in eine zweite Ausgleichsschiene (333) eingeführt ist, die in Längsrichtung des zweiten Drehelements (330) ausgebildet ist.

11. Elektronisches Gerät (101, 200) nach Anspruch 2, umfassend ferner:
eine Eingabevorrichtung (250, 600); und
einen Prozessor (120), der mit der Eingabevorrichtung (250, 600) und der Antriebsvorrichtung (430) verbunden ist, wobei
der Prozessor (120) dazu konfiguriert ist,
die Antriebsvorrichtung (430) so zu steuern, dass sie basierend auf einem in der Eingabevorrichtung (200) erzeugten ersten Eingangssignal eine Antriebswelle (431) der Antriebsvorrichtung (430) in einer ersten Richtung dreht;
die Antriebsvorrichtung (430) so zu steuern, dass sie auf der Grundlage eines in der Eingabevorrichtung (250, 600) erzeugten zweiten Eingangssignals die Antriebswelle (431) der Antriebsvorrichtung (430) in einer zweiten Richtung entgegen der ersten Richtung dreht;
die Antriebsvorrichtung (430) so zu steuern, dass sie die Drehung der Antriebswelle (431) auf der Grundlage des in der Eingabevorrichtung (250, 600) erzeugten dritten Eingangssignals anhält;
die Antriebsvorrichtung (430) so zu steuern, dass sie die Drehung der Antriebswelle (431) auf der Grundlage des Stromwerts anhält, der größer ist als ein Schwellenwert, der durch einen Stromsensor erfasst wird, der mit dem Prozessor (120) und der Antriebsvorrichtung (430) verbunden ist; und
die Antriebsvorrichtung (430) so zu steuern, dass sie die Drehung der Antriebswelle (431) auf der Grundlage eines Zustands des elektronischen Geräts (101, 200) anhält, das sich in einem entfalteten oder geschlossenen Zustand befindet.

12. Elektronisches Gerät (101, 200) nach Anspruch 2, umfassend ferner:
einen Eingabesensor; und
einen mit dem Eingabesensor verbundenen Prozessor (120), wobei
der Prozessor (120) dazu konfiguriert ist, die Antriebsvorrichtung (430) so zu steuern, dass eine Antriebswelle (431) der Antriebsvorrichtung (430) so konfiguriert ist, dass sie sich in der ersten Richtung dreht, basierend auf der Berührung in einer Richtung, die im Eingabesensor erfasst wird, und dazu konfiguriert ist, die Antriebsvorrichtung (430) so zu steuern, dass sich die Antriebswelle (431) der Antriebsvorrichtung (430) in der zweiten Richtung dreht, die der ersten Richtung entgegengesetzt ist, basierend auf der Berührung in der Richtung, die der einen Richtung, die im Eingabesensor erfasst wird, entgegengesetzt ist.

## Revendications

1. Dispositif électronique (101, 200) comprenant :
un premier logement (210) ;
un deuxième logement (220) ; et
un dispositif de charnière (300) reliant de façon pliante le premier logement (210) et le deuxième logement (220), dans lequel
le dispositif de charnière (300) comprend :
un support (310) comprenant un premier rail (311) et un deuxième rail (312) espacé du premier rail (311) ;
un premier élément rotatif (320) comprenant une première partie rotative (322) serrée au premier rail (311) du support (310) de sorte qu'il pivote par rapport au support (310) ;
un deuxième élément rotatif (330) comprenant une deuxième partie rotative (332) serrée au deuxième rail (312) du support (310) de sorte qu'il pivote par rapport au support (310) ;
un premier bras (340) qui comprend un premier engrenage (341), qui est relié au premier élément rotatif (320) afin de pouvoir pivoter par rapport au support (310), et qui est relié au premier logement (210) ;
un deuxième bras (350) qui comprend un deuxième engrenage (351), qui est relié au deuxième élément rotatif (330) afin de pouvoir pivoter par rapport au support (310), et qui est relié au deuxième logement (220) ;
un engrenage d'interfonctionnement (380) s'engrenant avec le premier engrenage (341) et le deuxième engrenage (351) et pivotant de façon correspondante ;
un premier élément limitant (410) agencé sur le support (310), le premier élément limitant (410) comprenant une première partie de corps (411), une première partie de contact (413) et un premier élément de pression (414) en matériau élastique afin de comprimer la première partie de contact (413) contre la première partie rotative (322) ;
un deuxième élément limitant (420) agencé sur le support (310), le deuxième élément limitant (420) comprenant une deuxième partie de corps (421), une deuxième partie de contact (423) et un deuxième élément de pression (424) en matériau élastique afin de comprimer la deuxième partie de contact (423) contre la deuxième partie rotative (332) ; et
un arbre (315) pénétrant le support (310) et étant configuré pour relier la première partie de corps (411) et la deuxième partie de corps (421),
dans lequel la première partie de corps (411) et la deuxième partie de corps (421) sont configurées pour pivoter par rapport au support (310).

2. Dispositif électronique (101, 200) selon la revendication 1, comprenant en outre un dispositif d'entraînement (430) configuré pour faire pivoter au moins l'un des éléments parmi le premier engrenage (341), le deuxième engrenage (351) et l'engrenage d'interfonctionnement (380).

3. Dispositif électronique (101, 200) selon la revendication 1, dans lequel
la première partie de contact (413) est agencée à une terminaison de la première partie de corps (411), et la terminaison de la première partie de corps (411) est comprimée via le premier élément de pression (414), et la deuxième partie de contact (423) est agencée à une terminaison de la deuxième partie de corps (421), et la terminaison de la deuxième partie de corps (421) est comprimée via le deuxième élément de pression (424).

4. Dispositif électronique (101, 200) selon la revendication 1, dans lequel
la rotation du premier élément rotatif (320) par rapport au support (310) est limitée via contact avec la première partie de contact (413), et
le deuxième élément rotatif (330) est configuré pour pivoter par rapport au support (310) via contact avec la deuxième partie de contact (423).

5. Dispositif électronique (101, 200) selon la revendication 1, dans lequel
le support (310) comprend une première partie d'assise (313) sur laquelle le premier élément de pression (414) est agencé et une deuxième partie d'assise (314) sur laquelle le deuxième élément de pression (424) est agencé.

6. Dispositif électronique (101, 200) selon la revendication 3, dans lequel
la première partie de contact (413) la deuxième partie de contact (423) comprennent respectivement un élément de palier (540) et sont configurés pour pivoter par rapport à la première partie de corps (411) et à la deuxième partie de corps (421) respectivement via l'élément de palier (540).

7. Dispositif électronique (101, 200) selon la revendication 1, dans lequel
la première partie rotative (322) et la deuxième partie rotative (332) incluent une partie circulaire (510) munie d'une section transversale circulaire, d'une partie d'arrêt (520) formée concave à la partie circulaire (510) et d'une partie terminale (530) qui est une terminaison de la partie circulaire (510), respectivement, et la première partie de contact (413) et la deuxième partie de contact (423) sont mises en contact avec au moins l'un des éléments parmi la partie circulaire (510), la partie d'arrêt (520) et la partie terminale (530) selon la rotation du premier élément rotatif (320) et du deuxième élément rotatif (330).

8. Dispositif électronique (101, 200) selon la revendication 7, dans lequel
la partie terminale (530) formée respectivement dans la première partie rotative (322) et la deuxième partie rotative (332) est formée d'au moins une partie faisant saillie depuis la partie circulaire (510).

9. Dispositif électronique (101, 200) selon la revendication 2, comprenant une plaque de friction (432, 433) qui est reliée à l'arbre d'entraînement (431) du dispositif d'entraînement (430) et est configurée pour pivoter par rapport au support (310), dans lequel
la plaque de friction (432, 433) est configurée pour faire pression sur au moins un élément parmi le premier engrenage (341), le deuxième engrenage (351) et l'engrenage d'interfonctionnement (380).

10. Dispositif électronique (101, 200) selon la revendication 1, dans lequel
le premier bras (340) est configuré pour pivoter par rapport au support (310) avec un arbre rotatif différent du premier élément rotatif (320), et est relié au premier élément rotatif (320) via une première broche (360) insérée dans un premier rail de compensation (323) formé dans le sens longitudinal du premier élément rotatif (320), et
le deuxième bras (350) est configuré pour pivoter par rapport au support (310) avec un arbre rotatif différent du deuxième élément rotatif (330), et est relié au deuxième élément rotatif (330) via une deuxième broche (370) insérée dans un deuxième rail de compensation (333) formé dans le sens longitudinal du deuxième élément rotatif (330).

11. Dispositif électronique (101, 200) selon la revendication 2, comprenant en outre :
un dispositif d'entrée (250, 600) ; et
un processeur (120) relié au dispositif d'entrée (250, 600) et au dispositif d'entraînement (430), dans lequel
le processeur (120) est configuré pour :
commander au dispositif d'entraînement (430) de faire pivoter l'arbre d'entraînement (431) du dispositif d'entraînement (430) dans une première direction sur la base d'un premier signal d'entrée généré par le dispositif d'entrée (200) ;
commander au dispositif d'entraînement (430) de faire pivoter l'arbre d'entraînement (431) du dispositif d'entraînement (430) dans une deuxième direction opposée à la première direction sur la base d'un deuxième signal d'entrée généré dans le dispositif d'entrée (250, 600) ;
commander au dispositif d'entraînement (430) de faire cesser la rotation de l'arbre d'entraînement (431) sur la base d'un troisième signal d'entrée généré dans le dispositif d'entrée (250, 600);
commander au dispositif d'entraînement (430) de faire cesser la rotation de l'arbre d'entraînement (431) sur la base d'une valeur actuelle supérieure à une valeur seuil détectée via un capteur de courant relié au processeur (120) et au dispositif d'entraînement (430) ; et
commander au dispositif d'entraînement (430) de faire cesser la rotation de l'arbre d'entraînement (431) sur la base d'un état du dispositif électronique (101, 200) étant à l'état déplié ou fermé.

12. Dispositif électronique (101, 200) selon la revendication 2, comprenant en outre :
un capteur d'entrée ; et
un processeur (120) relié au capteur d'entrée, dans lequel
le processeur (120) est configuré pour commander le dispositif d'entraînement (430) de sorte que l'arbre d'entraînement (431) du dispositif d'entraînement (430) est configuré pour pivoter dans une première direction sur la base d'un toucher dans une direction détecté dans le capteur d'entrée, et est configuré pour commander le dispositif d'entraînement (430) de sorte que l'arbre d'entraînement (431) du dispositif d'entraînement (430) pivote dans une deuxième direction opposée à la première direction sur la base d'un toucher dans une direction opposée à la une direction détecté dans le capteur d'entrée.
